# EUROPEAN PATENT SPECIFICATION

(11) **EP 0 908 922 B1**
(45) Date of publication and mention of the grant of the patent: **03.09.2003**
(21) Application number: 98400888.8
(22) Date of filing: 10.04.1998
(51) Int. Cl.: H01J 37/32

(54) **Process chamber for plasma processing and apparatus employing said process chamber**
Bearbeitungskammer zur Plasma Behandlung und diese Bearbeitungskammer benutzende Vorrichtung
Chambre de traitement par plasma et dispositif utilisant cette chambre de traitement

(30) Priority: 10.10.1997 EP 97402395
(43) Date of publication of application: 14.04.1999
(73) Proprietor: EUROPEAN COMMUNITY, 1049 Brussels (BE)
(72) Inventor: Colpo, Pascal, 74960 Meythet (FR); Daviet, Jean-François, 74960 Cran-Gevrier (FR); Ernst, Roland, 38610 Gieres (FR); Rossi, François, 21021 Biandronno (IT)
(74) Representative: Schmitt, Armand

(56) References cited:
- EP-A- 0 403 418
- EP-A- 0 782 172
- EP-A- 0 801 413
- WO-A-97/42648
- GB-A- 2 073 999
- US-A- 3 879 597
- US-A- 4 795 879
- US-A- 5 556 521
- US-A- 5 641 375
- CURRY W J ET AL: "SUPPRESSION SHIELD FOR RF PLASMA" IBM TECHNICAL DISCLOSURE BULLETIN, vol. 22, no. 11, April 1980, page 4909/4910 XP002023803
- PATENT ABSTRACTS OF JAPAN vol. 017, no. 205 (C-1051), 22 April 1993 & JP 04 350156 A (ISHIKAWAJIMA HARIMA HEAVY IND CO LTD), 4 December 1992

## Description

### Description For the Following contracting states : AT, BE, DK, ES, FI, GR, IE, LU, PT and SE

The present invention generally relates to the field of plasma surface treatment and, more particularly, to a process chamber for such purposes. The invention also relates to a plasma processing apparatus implementing the aforementioned process chamber and to its use for plasma processing.

The plasma treatment envisaged by the present invention is not limited to specific applications or techniques. Examples of applications in this field notably include plasma enhanced chemical vapour deposition (PECVD), also known as plasma assisted chemical vapour deposition (PACVD).

Chemical vapour deposition (CVD) in general is a technique for treating a surface of a workpiece, e.g. a substrate, by immersing the latter in a precursor gas or precursor gas mixture of selected materials within a process chamber. The materials in gaseous form, known as active species, can be deposited on the workpiece surface under controlled conditions (gas composition, pressure and temperature, and surface temperature, etc.). The composition of the immersing gas can also be chosen to etch away the surface of the workpiece at chosen areas using a mask.

Classical CVD generally requires the workpiece to be kept at a fairly high temperature to initiate and sustain the deposition of a film thereon, being essentially a thermally-driven process. It works satisfactorily (ignoring some more specific issues such as thermal stress) all the while the substrate can withstand the temperature that makes the process economically viable.

When this condition cannot be met, it is usual to overcome the temperature limitation by resorting to PECVD, which involves creating a plasma inside the process chamber to enhance vapour deposition (this technique is also known as plasma-assisted chemical vapour deposition (PACVD)).

The species generated by a plasma are characteristically different from those contained merely in the gas phase of the same precursor species used in classical chemical vapour deposition. This can be explained by the fact that plasma is intrinsically a medium in thermodynamic non-equilibrium. Although the actual phenomena that occur in a plasma are extremely complex, it can be said that, in general, the purely thermal activation of a classical CVD reaction generated by a high substrate temperature can be switched to the plasma phase in which the active species are pre-cracked in the plasma instead of being cracked only at the level of the hot substrate surface. Consequently, plasma-enhanced CVD allows a dramatically lower substrate temperature than with gaseous CVD for comparable film deposition characteristics.

PECVD is nowadays used extensively in the field of surface engineering, e.g. for etching or deposition of various materials. It offers levels of performance unattainable by the other, more classical techniques.

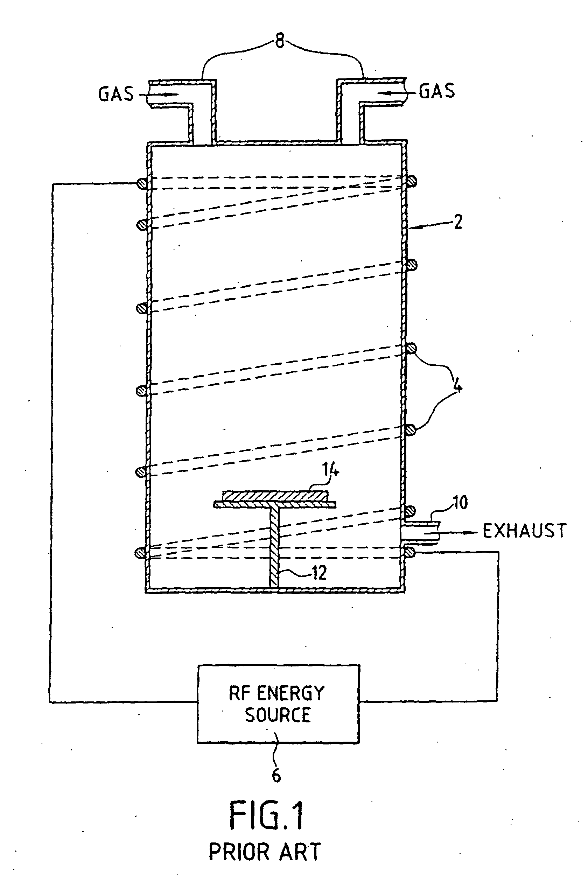

Figure 1 illustrates very schematically the main parts of a classical PECVD apparatus in which a plasma in generated by inductive coupling, currently one of the most versatile and reliable method of plasma generation for industrial applications.

The apparatus comprises a cylindrical reaction vessel 2 made of dielectric material, such as a quartz, surrounded by a radio-frequency (RF) inductor in the form of a helical electrode 4 connected to an RF energy source 6. When activated, the electrode 4 induces an RF electromagnetic energy field inside the reaction vessel 2 such as to create a plasma with the precursor gases by RF coupling.

In order to establish the gas conditions, the vessel 2 comprises a number of inlets 8 for controllably admitting the precursor gas or gases. It is also has an outlet 10 connected to an exhaust pump (not shown) to establish the required low pressure conditions and to evacuate used reaction gases.

A stage 12 having a T-shaped cross-section is provided in the vessel 2 for supporting a workpiece 14 at an optimum position within the plasma.

For the sake of simplicity, the means for accessing the chamber and handling the workpiece are not shown nor discussed, these being well-known in the art.

In operation, a workpiece 14 - which can be an insulator, semiconductor or conductor - is introduced onto the stage 12. The vessel 2 is then evacuated to a pressure corresponding to a partial vacuum, and a precursor gas or gas mixture is introduced through the inlets 8. The precursor gas used contains atoms or molecules of the material to be deposited in a form that can be liberated by the plasma in the process chamber 2, and is often admixed with deposition-enhancing components. The deposited material can be insulating or electrically conductive.

The RF energy source 6 is activated so as to induce a plasma of appropriate characteristics within the vessel. The plasma in the chamber breaks down the gas into its precursor species, which are then deposited in a controlled manner on the surface of the workpiece to form a layer of material corresponding to the precursor.

A problem arises with this type of apparatus when used for depositing layers of electrically conductive material. In this case, some of the atoms or molecules of the precursor gas containing the conductive material tend to migrate to the internal surface of the chamber walls and, over time, form a conductive film thereon. The conductive film tends to screen out the electromagnetic energy delivered by the RF inductor electrode 4. This phenomenon subsequently makes it impossible to sustain a plasma inside the process chamber, the electromagnetic energy being absorbed by the electrically conductive film instead of the plasma itself. The industrial consequence is a drift in the process performance and frequent downtime for cleaning the chamber walls.

To overcome this problem, some forms of PECVD apparatus have the inductor electrode contained inside the process chamber itself, so that the inner surface of the chamber walls is outside the RF energy field and hence outside the space occupied by the plasma.

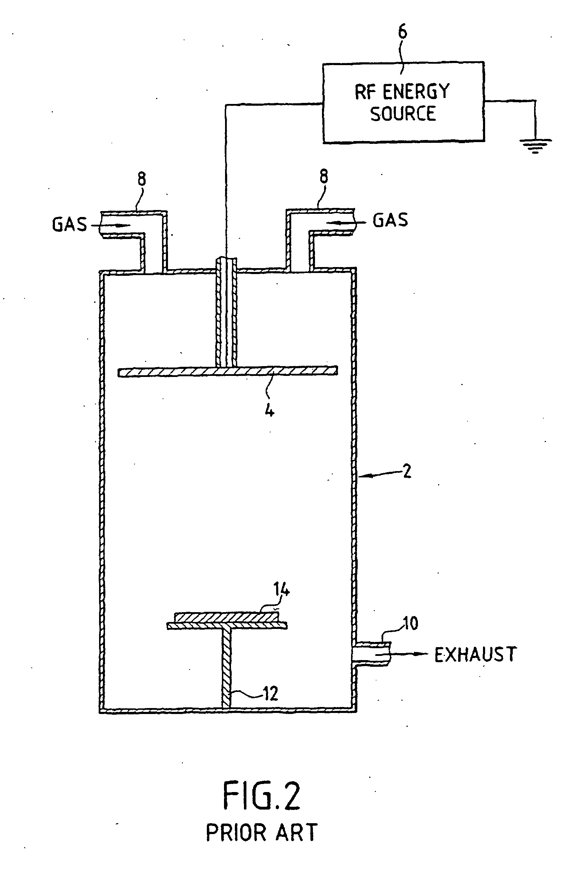

Such an apparatus is illustrated very schematically in figure 2, where elements corresponding to those of figure 1 are identified by like references and shall not be discussed further in any detail. The RF inductor electrode 4 has a plate-like structure and is installed inside the process chamber 2, above the stage 12. The latter can be isolated or biased to establish and maintain the plasma.

An example of such an apparatus is disclosed in document EP-A-0 424 620.

However, this approach brings problems of its own, including :
- the material of the RF electrode, being immersed in the plasma and reaction gas environment - at least at the level of its exposed surface - becomes a source of uncontrollable contamination, notably through sputtering by high-energy particles in the plasma, and
- the RF electrode additionally generates a very high and uncontrolled electric field within the plasma, which can create non-uniformities over the deposition surface.

Documents US-A-4 795 879, US-A-5556521 and EP-A-0 782 172 show examples of plasma processing apparatuses. Document EP-A-0 801 413 which constitutes a prior art according to Article 54(3) EPC, describes a plasma chamber including a slotted Faraday-sputter shield which is formed to provide no line-of-sight path therethrough.

An object of the present invention is to overcome the problem of unwanted film deposition on the inner surface of the process chamber without resorting to provide the inductor electrode inside the chamber.

The process chamber envisaged by the invention is bounded by wall portions and adapted to receive electromagnetic energy by inductive coupling from an external inductor connected an ac supply, to create, enhance or sustain a plasma therein, the chamber comprising conductive means arranged within said chamber to confront at least a part of the internal surface of the wall portions such as to inhibit coating thereon of material evolved from plasma processing, characterised in that the conductive means is arranged at a distance of less than 10 mm from the internal surface.

The conductive means thus effectively constitutes a trap for condensing conductive material particles in the plasma before they can reach the inner surface of the wall portions.

Over time, the film of conductive material that would otherwise be formed on the inner wall portions of the process chamber accumulates instead on the conductive means. However, this accumulation is not detrimental since it forms on surfaces which are already electrically conductive.

In preferred embodiments of the invention, the conductive means comprise a conductive structure having an outer surface that follows an internal contour of at least part of the wall portions of the process chamber.

The conductive means are arranged at a predetermined distance from the internal surface. This distance, which can be determined from Paschen's law on the ionisation of gases, is relatively small, optimum results usually being obtained with values of less than 10 mm. For many types of process chamber, the distance can be a value less than 1 mm.

Alternatively, the conductive means can have at least a substantial portion thereof in physical contact with the internal surface of the chamber.

The outer surface of the conductive structure can be configured to follow a substantial proportion of the wall portions. In this case, it may comprise one or more apertures to allow the passage of electromagnetic energy into the chamber.

The presence of one or more apertures in the case where the conductive means constitutes, to some extent at least, a Faraday cage can produce two significant effects.

Firstly, the aperture(s) (e.g. in the form of slits) divide the conductive means into a plurality of sectors, each sector being a portion of contour of the conductive means. In the presence of the plasma-inducing electromagnetic field, these sectors serve as intermediate inductors in accordance with Lenz's law. Basically, the conductive means can be considered as being placed in an inductor having a current Iind flowing therethrough. The inductor generates a magnetic field in all the environing space, giving rise to flux variations in the conductive means. The conductive means tends to cancel these flux variations by creating its own induced currents.

This phenomenon takes place between the inductor and each sector of the conductive means forming a Faraday cage. Induced currents created within each sector themselves create currents that are induced into the plasma.

The presence of one or more apertures can prevent such induced currents from forming loops extending around the entire periphery of the conductive means, and which would otherwise tend to short-circuit the magnetic field.

Secondly, the aperture(s) help to enhance the passage of electromagnetic energy into the process chamber.

Because the conductive material particles accumulate on the conductive surface of the structure, the apertures remain clear even after prolonged use. There is thus no drift in the performance characteristics of the process chamber over time.

The apertures may be in the form a series of slits following an arbitrary pattern.

The apertures can be configured to define an indirect path for the electromagnetic energy from the inductor to inside the chamber. In other words, the configuration of apertures is such that it does not allow a direct line of view into the chamber from the outside.

If the process chamber has a regular geometry and the RF electromagnetic energy is to be present homogeneously inside, the apertures are preferably distributed uniformly over the conductive means.

In a preferred embodiment, the conductive means comprises a series of conductive elements dependent from a mechanical support means and distributed so as to form an array that confronts the internal surface of the chamber. In this case, the aforementioned apertures can be advantageously defined by spaces separating neighbouring conductive elements.

The conductive elements can be profiled so as to overlap in a non-contacting manner with neighbouring conductive elements in order to define the indirect path for the energy field.

The conductive elements can also be imbricated in a non-contacting manner with their neighbouring conductive elements at confronting edges to define the indirect path.

The conductive elements can conveniently be constructed as a series of elongate rectangular panels whose major length extends parallel to a principal axis of the process chamber.

In embodiments of the invention in which the conductor means is in physical contact with the internal wall of the chamber, the conductor means can be mechanically biased against that internal wall, e.g. by resilient mounts provided at the level of the mechanical support.

In a classical application, the conductive means bounds a space inside the chamber, within which a plasma condition is to be created. This space may include the space containing the workpiece to be received or it may be outside the workpiece. The latter possibility can be chosen e.g. for deposition of a material at a post plasma discharge position of the chamber. In this case, an inlet may be provided for reaction material, e.g. a gas or gas mixture, outside the space bound by the conductive means.

It is also possible according to the present invention to dispose of a source of plasma material, such as an ion source, within the chamber itself.

Advantageously, the source of plasma material can be constituted by the conductive means itself. Thus, in addition to protecting the wall portions of the chamber, the conductive means can also serve e.g. as a source of metal ions for plasma deposition. To this end, the conductive means is composed - at least in part
- of the material(s) constituting the desired deposition. The conductive means can thus be activated by being connected to a dc or ac source (including radio frequencies) to activate particle sputtering from its constituant material(s).

The ions freed in this way are re-ionised by the induced plasma created by ionised gases through the induced energy field.

It has been found by the applicant that the source of plasma material can thereby be stronger by comparison with techniques based on the admission of the material in gaseous form.

Moreover, this technique makes it possible to create a reactive plasma whilst obviating the need to use a dangerous gas. For instance, a conductive means made - at least in part - of tungsten can replace the use of a tungsten hexafluoride (WF₆), which, being a fluourised gas, is potentially hazardous.

The use of the conductive means as an ion source is possible in embodiments where the workpiece is immersed in the induced energy field, i.e. where the conductive means would thereby preferably bound a space containing the workpiece, as well as where the workpiece is outside that space, for a post plasma discharge deposition.

The source of plasma material inside the chamber can also comprise a cathode associated with an electrical energy source, such as a magnetron. The cathode can conveniently be provided at an end portion of a space bound by the conductive means, for instance at one end of the plasma processing chamber.

The ion source may also comprise a source of metallic vapour and activating means, such as an electron (or other particle) beam generator for transmitting energy to vaporise that source.

It has been found that the effectiveness of the conductive means can be greatly enhanced if it is cooled, e.g. by a fluid flow.

To this end, the conductive means can comprise a conduit arrangement for allowing a flow of thermal fluid and connected to a cold source for ensuring cooling thereof.

Depending on operating conditions (plasma characteristics, precursor gases, etc.) the efficiency of the conductive means can also be improved if means are provided for electrically biasing them with an ac voltage (including an RF voltage) or a dc voltage (including ground).

In this case, the conductive means can be divided into two or more isolated sections, the biasing means being operative for biasing the sections separately.

The conductive means can further comprise a window portion to enhance plasma ignition.

The window can be associated with shutter means for adjusting the degree of opening of the window.

If needs be, the process chamber can comprise a workpiece-supporting stage which is connectable to a biasing source to bias a workpiece on the stage, either directly or via a temperature-controlled susceptor, with an ac voltage (including an RF voltage) or a dc voltage (including ground).

The process chamber can further comprise a sputtering target.

The present invention also concerns a plasma processing apparatus, e.g. for plasma enhanced chemical vapour deposition or plasma processing by re-ionisation, comprising :
- a process chamber based on the conductive means as precedingly defined,
- an electromagnetic energy inductor for delivering electromagnetic energy to the process chamber, and
- an energy source for driving the inductor.

Depending on the embodiments, the apparatus may also comprise biasing means for biasing the conductive means with an ac voltage (including an RF voltage) or a dc voltage (including ground).

These biasing means can comprise means for independently biasing the two or more isolated sections of the conductive means, if the latter is so configured.

Finally, the present invention also concerns the use of plasma processing apparatus as defined above for :
depositing a conductive film on a substrate,
ion etching on a substrate, or
processing a workpiece by re-ionisation, the ion source being either the conductive means itself, a cathode or a vaporisable source, or indeed any other appropriate source.

The invention will be better understood from the following description of preferred embodiments, given strictly as non-limiting examples, with reference to the appended drawings in which :
- figure 1 is a highly simplified sectional view of a classical PECVD apparatus with RF coupling of the electromagnetic energy field through the process chamber;
- figure 2 is highly simplified sectional view of a prior art PECVD apparatus with the electromagnetic energy field generated within the process chamber;
- figure 3 is a simplified general view of a PECVD apparatus according to a first embodiment of the present invention;
- figure 4a is a plan view of an aperture pattern formed by a conductive structure used in the apparatus of figure 3 according to a first variant of the invention;
- figure 4b is a partial perpective view of the conductive structure shown in figure 4a;
- figure 5a is a partial perspective view of an aperture pattern formed by a conductive structure used in the apparatus of figure 3 according to a second variant of the invention;
- figure 5b shows a detail of the conductive structure shown in figure 5a;
- figure 6a is a partial perspective view of an aperture pattern formed by a conductive structure used in the apparatus of figure 3 according to a third variant of the invention;
- figure 6b shows a detail of the conductive structure shown in figure 6a;
- figure 7 is a perspective view of the conductive structure and mount therefor according to a second embodiment of the invention;
- figure 8 is plan view of a conductive structure and mount therefor according to a first variant of the second embodiment;
- figure 9 is a plan view of a conductive structure and mount therefor according to a second variant of the second embodiment;
- figure 10 is a plan view of a conductive structure and mount therefor according to a third variant of the second embodiment;
- figure 11a is a general view of the conductive structure of figure 3 equipped with a cooling system;
- figure 11b is a partial plan view of the conductive structure of figure 11a and its positioning with respect to the process chamber;
- figure 12 is a general view of a variant of the conductive structure shown in figure 10;
- figure 13 is a simplified view of a plasma processing chamber adapted for processing a workpiece at a post plasma discharge position, according to a third embodiment of the invention;
- figure 14 is a simplified view of a plasma processing chamber implemented for ion flux re-ionisation by means of an internal sputtering target; and
- figure 15 is a simplified view of a plasma processing chamber implemented for ion flux re-ionisation by means of an internal electron beam evaporator.

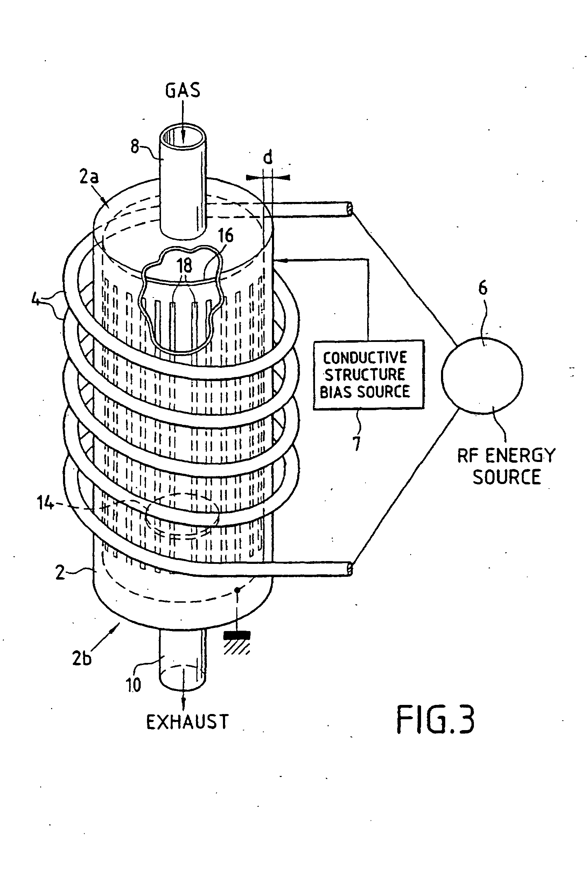

A PECVD apparatus in accordance with the present invention is shown in figure 3. For simplicity and conciseness, the parts of this apparatus which are analogous to those of figures 1 and 2 are given the same reference numerals and their functional role shall not be repeated.

In the example, the process chamber 2 is generally cylindrical, with its curved wall portion made of a dielectric material such as quartz. Because the dielectric material is transparent to the radio frequencies used, the electromagnetic energy generated by the RF energy source 6 is transmitted directly from the inductor electrode 4 through to the interior of the process chamber 2. In some other types of process chamber envisageable with the invention, the walls may be made largely of conductive material, in which case a dielectric window needs to be formed on one or several parts of the walls to allow adequate RF transmission from the inductor electrode 4 to the interior of the process chamber.

The top wall 2a and bottom wall 2b of the process chamber are made of stainless steel, and respectively include a reaction gas inlet 8 and an exhaust outlet 10.

The process chamber 2 also comprises means for maintaining a workpiece 14 inside the plasma environment. In the example, the workpiece 14 (e.g. a substrate) is held in suspension at a central position of the process chamber, e.g. by cables (not shown): Alternatively, the process chamber can be provided with a stage, as shown in the examples of figures 1 and 2, or any other known supporting structure.

If the process chamber 2 has a stage, the latter can be connected to a biasing source (not shown) to bias the workpiece (e.g. a substrate), either directly or via a temperature-controlled susceptor. For biasing, an ac voltage (including an RF voltage) or a dc voltage (including ground) may be used.

According to the invention, the process chamber 2 contains an electrically conductive structure 16. Its purpose is to inhibit the deposition of conductive vapour deposition material on the inner surface of the walls of the process chamber 2.

A biasing source 7 is connected to the conductive structure to bring the latter to a dc or ac potential (including radio frequencies) or to provide a ground connection, according to implementation of the apparatus and the mode of operation.

The conductive structure 16 is generally cylindrically shaped and positioned close to and concentrically with the cylindrical chamber wall. It is made from sheet metal, such as copper, having sufficient thickness to ensure minimal distortion under its own weight and over the temperatures existing inside the process chamber 2.

The radial separation d between the inner surface of the chamber wall and the outer surface of the conductive structure 16 is chosen such that no plasma is created between these two surfaces. The appropriate value of this separation d can be determined analytically using Paschen's law of ionisation in gases, or empirically. This value is a function of the chamber geometry, design of the conductive structure, frequency and intensity of the RF energy, as well as gas composition and pressure.

In the example based on a cylindrical, quartz process chamber operating at a pressure on the order of 100 milli Torr (converted as 13.3 Pa), it has been found that excellent results can be obtained for a large variety of gases with the separation d kept to 1mm or less.

The conductive structure 16 can be held in position within the process chamber 2 by any suitable means. In order to ensure that the separation d is maintained accurately with respect to the cylindrical chamber 2, the inner wall of the latter can be provided with a series of ribs (not shown) projecting inwardly by an amount corresponding to the separation d. The outer surface of the conductive structure 16 is then held in abutment against the ribs, either by elasticity of its constituent material, or by mechanical mounts, adhesives or the like. The fixing of the conductive structure 16 inside the process chamber 2 may not necessarily be permanent. It is possible to make the conductive structure detachable from the process chamber to allow easy access both to the chamber itself, e.g. for insertion/removal of workpieces and to the conductive structure, e.g. for cleaning.

In order to allow adequate transmission of the RF energy into the process chamber 2, the conductive structure 16 is provided with a series of apertures formed uniformly over its surface. In the example of figure 3, the apertures are in the form of slits 18 that extend parallel to the principal axis of the conductive structure 16. The slits can of course be arranged to extend along other directions, e.g. obliquely with respect to the main axis of the process chamber. They can be continuous or divided into length segments over their path. The latter possibility can be chosen if required to make the conductive structure more rigid. In the example, the area occupied by the apertures corresponds to around e.g. 5 to 35 % of the total surface of the conductive structure. However, these values are only indicative; the area occupied by the apertures and their configuration can be adapted to design criteria for suitably diminishing losses and induced currents as explained above.

The slit-like apertures 18 in figure 3 are formed by cut-outs, corresponding to the slits, formed along length portions of a closed cylinder. The shielding means thereby has an integral structure.

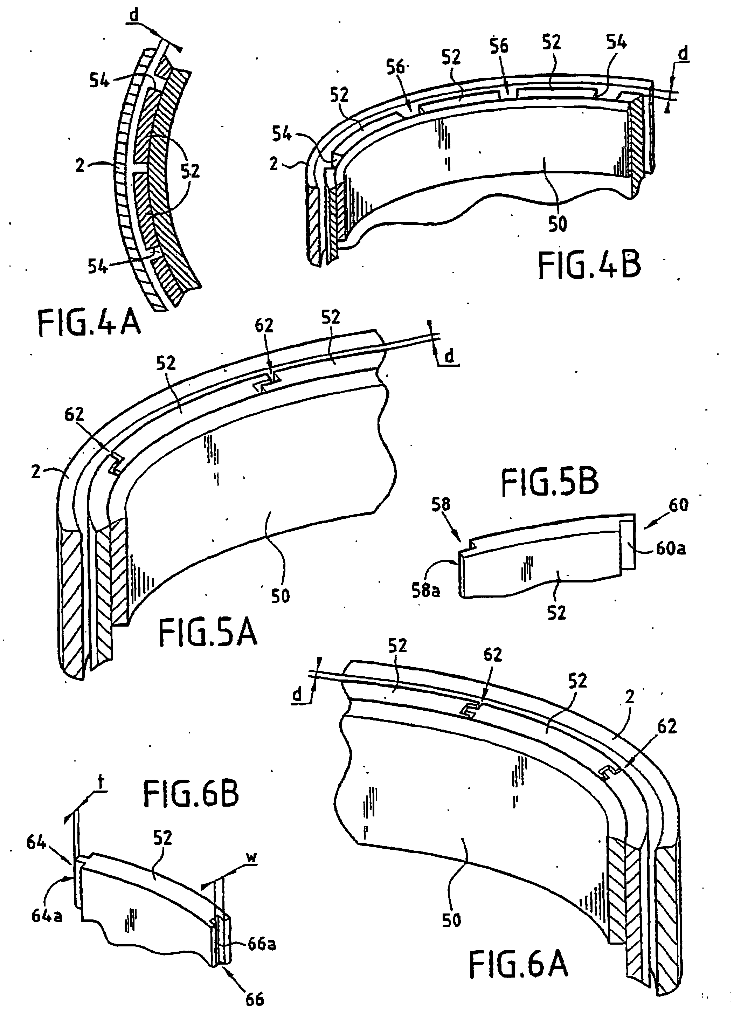

Alternatively, the shielding means can have a composite structure as shown in figures 4a and 4b. In the illustrated example, it is composed of upper and lower support rings 50 (only the upper ring is shown in the figures) to which are fastened the respective ends of a series of elongate metal panels 52. The series of metal panels 52 extends around the circumference of the support rings 50, each panel having straight longitudinal edges 54 and being separated from its neighbour by a small gap 56. The height (axial length) of the support rings is preferably made as small as possible in order to maximise the effective length of slits and thereby also to maximise the axial length portion of the conductive means that is effective for inductive coupling. The width and the pitch of the gaps 56 is such as to provide a series of openings corresponding in form and function to the slits 18.

Two variants of the above composite structure are shown in figures 5a, 5b and 6a, 6b, respectively. In these two variants, the metal panels 52 have profiled edge portions such as to allow an imbrication between neighbouring panels. This arrangement ensures that the panels 52 occupy the entire perimeter of the shielding means 16, leaving no straight passages for lines directed along a radial direction with respect to the principal axis. The imbricated portions of neighbouring panels are not contiguous, being separated by a predetermined gap which forms a labyrinthine passage for the field from the inductor 4 to the process chamber 2. In this way, the imbrication of the panels eliminates direct lines of view between the plasma and the dielectric chamber.

In figures 5a and 5b, each of the two longitudinal edges of the panels 52 defines a step 58 and 60 so as to present a face 58a and 60a turned respectively outwardly and inwardly relative to the principal axis of the conductive structure. The panels 52 are relatively positioned at their edges so that an inwardly turned face 60a confronts an outwardly turned face 58a, thereby forming an imbrication of the panels 52 around a complete closed path. The overlapping step portions 58, 60 of neighbouring panels 52 are separated from each other by a predetermined space 62 to create the aforementioned gap. The passage for the field thereby defined by the space 62 follows round the confronting step portions 58, 60.

In figures 6a and 6b, the two edges of the panels respectively define an elongate tongue 64 and an elongate groove 66 adapted to receive a corresponding tongue. Both the tongue 64 and the groove 66 extend along the respective edges of the panel 52. The panels 52 are assembled to form a complete closed path, with the tongue 64 at the edge of one panel 52 received in the groove 66 of the neighbouring panel. The grooves 66 have a width w exceeding the thickness t of the tongues 64, and the tips 64a of the tongues are recessed from the bottom 66a of the groove to create an intermediate space 62 that defines the aforementioned gap. The passage for the field defined by the gap thus follows round the internal surfaces of each groove 66.

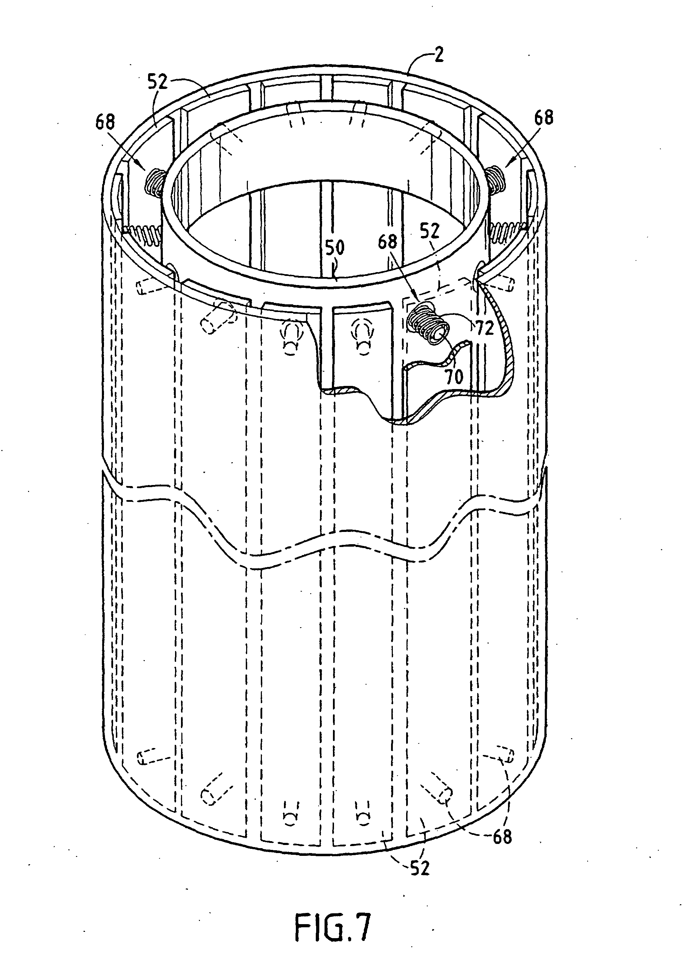

The examples illustrated in figures 3 to 6 show the conductive structure separated from the internal wall of the plasma processing chamber 2 by a small distance d. An alternative arrangement shall now be described with reference to figure 7, in which the conductive structure is instead in physical contact - at least at major portions thereof - with the internal wall of the chamber 2.

The conductive structure is constructed in a manner similar to that described with reference to figures 4a and 4b as far as the general configuration of the conductive panels 52 and their disposition are concerned. However, the panels 52 are in this case mounted on upper and lower support rings 50 through resilient mounts adapted to press the panel 52 radially outwardly against the inner wall of the chamber 2. Each mount 68 comprises a stem portion 70 attached to the support ring 50 and projecting radially outwardly from the latter. A compression coil spring 72 is engaged axially with the stem 70 such that its respective ends press against the support ring 50 and the inner face of the conductive panel 52. Similar resilient mounts 68 are provided at the lower ring and, if necessary also at one or several intermediate support ring(s).

The resilient mounts 68 are adapted to provide sufficient pressure to ensure a good contact of the panels 52 with the internal surface of the chamber 2 over the thermodynamic cycles experienced in use. The differential expansion coefficients between the chamber wall and the conductive panel structure are absorbed by the resiliency of the mounts, resulting in no significant distortion of the conductive structure or excessive stress on the chamber wall.

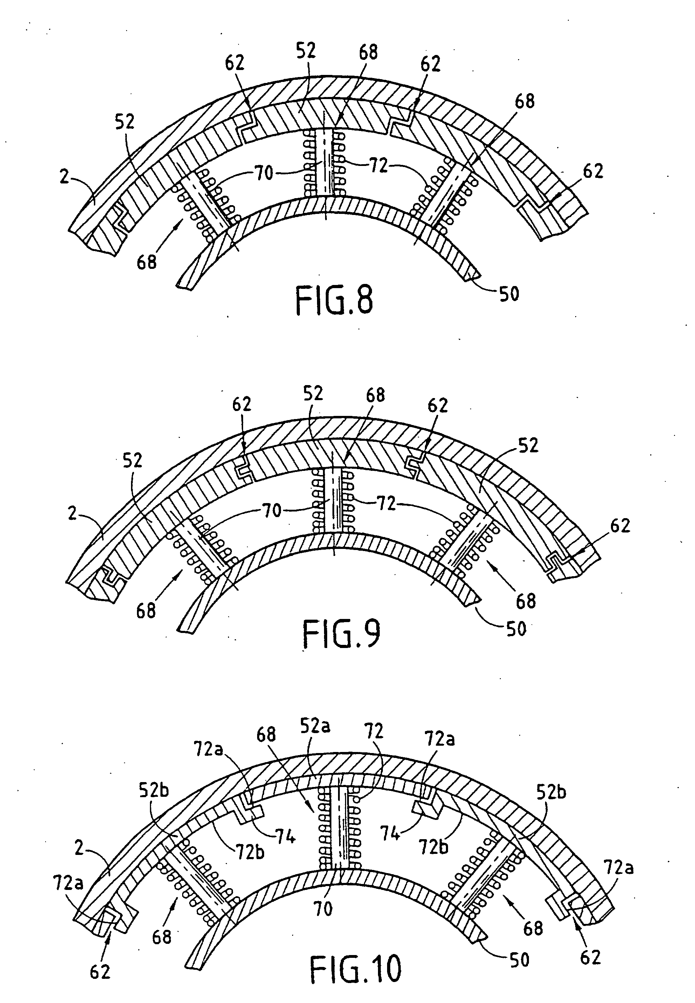

Figures 8 and 9 show the arrangement of the resilient mounts described with reference to figure 7, adapted to support the conductive panels with profiled edges shown in figures 5a and 6a respectively, imbricated to prevent a direct view to the chamber from the outside. Here, as in figures 5 and 6, the profile features and the gaps created therebetween are formed in the thickness of the panels.

Figure 10 shows a variant in which the edge profiles of the panels are formed instead by folding the panel-forming material. In the example, only one panel 52b in two is profiled, the profiled panels being arranged in alternation with straight panels 52a so as to form a closed path. The profiled panels 52b have at each of their edges two longitudinal right-angle folds 72a and 72b so as to form a wing 74 in a plane parallel to that of the main, central portion of the panel and radially inwardly displaced with respect to the latter. Each wing 74 thereby overlies an edge portion of a neighbouring, non-profiled panel. The width and amount of inward radial displacement of the wings 74 determine the size and shape of the gap 62 between neighbouring panels 52a, 52b that forms the labyrinthine path for the field.

It will be apparent that there are many possible ways of folding the edges of the conductive panels to form imbrications to avoid a direct view across the conductive structure whilst allowing the passage of energy field.

The conductive structure 16 is shown to be electrically grounded in the PECVD apparatus of figure 3.

However, it is also envisageable to provide means for biasing the conductive structure 16 with an ac voltage (including an RF voltage) or a dc voltage. In this case, the conductive structure can be divided into two or more isolated sections, each receiving an independent bias voltage from a respective biasing source. In the embodiments based on a composite structure, the panels 52 can conveniently be biased individually or in small groups. In this case, the resilient mounts 68 or direct connections to the upper and lower support rings 50 can be electrically insulated and provided with appropriate contact means for connection to a biasing source.

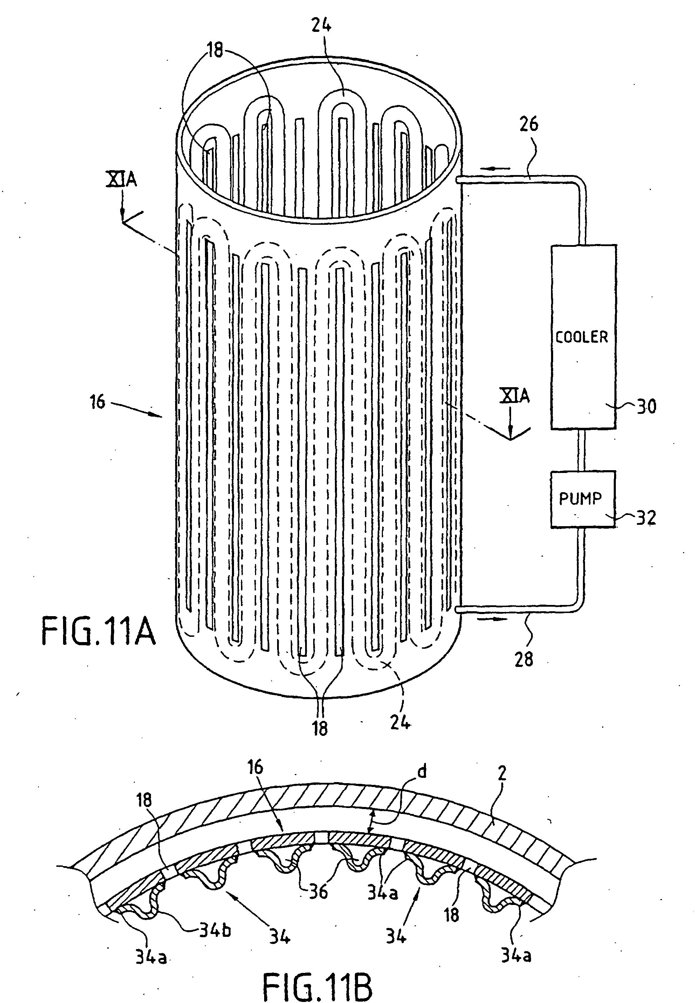

Figure 11 shows the conductive structure 16 implemented in the apparatus of figure 3, additionally provided with a cooling arrangement. The cooling arrangement comprises fluid conduits 24 incorporated into the conductive structure 16 and communicating through an inlet 26 and an outlet 28 with a fluid cooler 30 and a pump 32 in a closed system. The cooling fluid used can be water, possibly with some additives, oil or any other liquid. Cooling may also be effected by forced air passing through the conduits 24.

The incorporation of the fluid conduits 24 into the conductive structure 16 is shown in more detail in figure 11a. The fluid conduits 24 are formed by narrow, profiled metal strips 34 that run along a substantial portion of the axial length of the conductive structure 16. In the example, there is provided a conduit 34 between each pair of slits 18. The strips have a tab portion 34a at each longitudinal edge and an arcuate portion 34b between the tab portions. The tab portions 34a are sealingly attached, e.g. by welding, to the inner surface of the conductive structure at a region between the slits 18 and parallel to the latter. The arcuate portion 34b of the strip creates a channel 36 with the confronting inner surface of the conductive structure 16, allowing passage of the cooling fluid.

The metal strips 34 are interconnected at end portions of the conductive structure so that their respective channels form a continuous serpentine conduit configuration between the fluid inlet 26 and outlet 28.

It can be noted that with this construction, the cooling system forms an integral part of the conductive structure, being in direct physical contact with the cooling fluid. The heat generated at the structure is thereby evacuated very efficiently. Moreover, the strips 34 create negligible shadowing of the apertures (in this case formed by the slits 18).

The above-described conduits can of course be implemented with a conductive structure shown in figures 4a to 10, or indeed any other type of aperture configuration.

Alternatively, the conduits can be implemented by an arrangement of pipes and radiator fins attached to the conductive structure in accordance with standard practices for heat sinks.

It has been found by the applicant that by maintaining the conductive structure cool, the deposition rate of conductive material onto its inner surface is reduced dramatically.

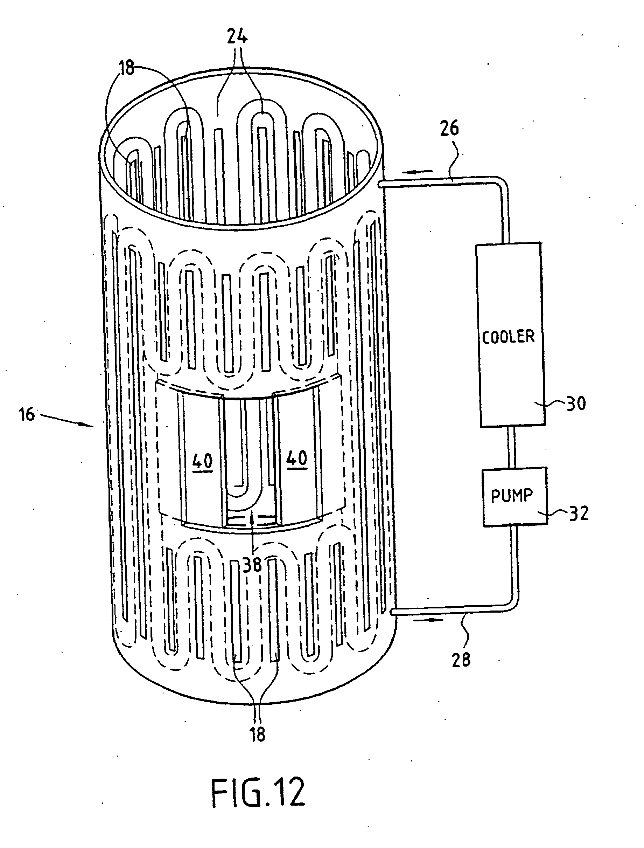

Figure 12 shows a variant of the conductive structure described with reference to figure 11 that features an adjustable window to help establish plasma electrostatic ignition.

The window 38 comprises a cut-out portion of the conductive structure 16 located e.g. mid-way between the ends of the latter and occupying e.g. 10 to 25% of its circumference. The window area is selectively adjustable between open and closed states by means of a pair slidable conductive shutters 40. The shutters 40 follow the contour of the conductive structure 16 and are mounted on the inner face of the latter so as leave the free the small separation d between the outer face of the conductive structure and the inner face of the reaction chamber wall. Each shutter 40 is slidable, either manually or by a remote control mechanism (not shown) in a circumferential direction to close a selected portion of the window cut-out 38.

The apertures in conductive structure 16, whether they be slits 18 or elementary cut-outs 20 or 22 stop short of the boundaries of the window area 38 to allow the passage and interconnection of the cooling conduits 24 around that area.

Although only one window cut-out 38 is shown in the figure, it can be envisaged to provide several windows for the same purpose. The windows may be distributed around the circumference of the conductive structure and/or superposed along the principal axis of the latter.

It should be noted that the conductive structure in all of the embodiments described can be further provided with additional apertures for allowing access to the process chamber.

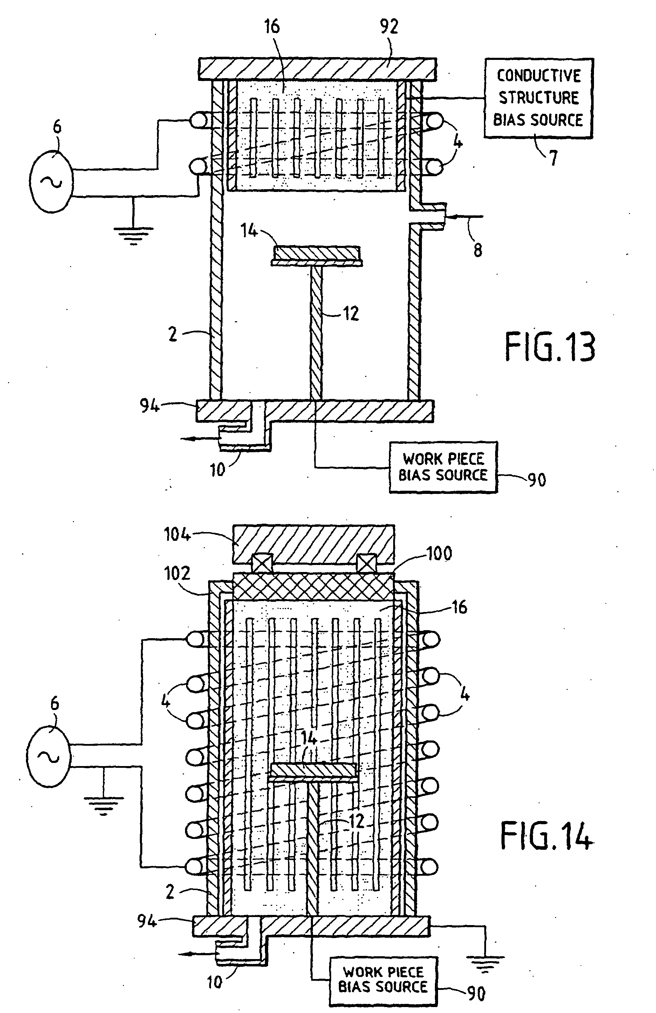

Figure 13 shows another embodiment of a plasma processing chamber 2 in accordance with present invention which differs from the one of figure 3 essentially in that the conductive structure 16 and inductor winding 4 are present only at a top portion of the chamber 2, above a stage 12 for supporting a workpiece 16. The stage 12 is connectable to a dc or ac source 90 to bias the workpiece thereon. This arrangement allows material deposition or other forms of processing to be effected on the workpiece under post plasma discharge conditions.

The conductive structure is connected to a biasing source 7 as in the embodiment of figure 3.

In the example, the reaction chamber comprises a quartz cylinder 2 terminated at each end respectively by upper and lower flange faces, 92 and 94. The conductive structure 16 - which can adopt any of the forms described with reference to figures 3 to 12 - is suspended from the top flange face 92.

The process gas or gas mixture is introduced from an inlet 8 formed in the quartz cylinder 2 between the bottom of the conductive structure 16 and the stage 12. It is also envisageable to provide injection from the upper part of the reaction chamber. Vacuum pumping of the chamber is effected through an outlet 10 at the lower flange face.

In the embodiments of plasma processing chamber described above, the reactive material is introduced in gaseous form from outside the chamber through an inlet.

However, the conductive means 16 can serve as a source of reactive material in addition to the function of preventing unwanted deposition on the internal walls of the chamber. In this case, the material of the conductive means is chosen to contain - either wholly or in part - the constituent to serve as a material to be deposited on the workpiece. All conductive structures described above can be made to provide this additional function.

The means for implementing the processing chamber according this aspect of the present invention are basically identical to those described above and will therefore not be repeated for conciseness. The conductive structure biasing source 7 is in this case adapted to provided a suitable bias to cause sputtering from the conductive structure. The bias can be a dc or an ac signal.

Depending on applications, the substrate holder 12 - and hence the workpiece 14 - can be biased to ensure optimal conditions.

Many materials can be chosen for constituting - or for incorporation into-the conductive structure. For example, the material can be tungsten for depositing tungsten material on the workpiece 14. In this manner, the use of the conductive structure 16 as an ion source obviates the classical requirement of introducing tungsten hexafluoride into the chamber 2.

Figure 14 shows another embodiment of a plasma processing chamber in accordance with the present invention, designed to function as a reactor for the reionisation of metal ions e.g. for ion sputtering applications. Its construction is similar to that of figure 13 at the level of the quartz cylinder 2, lower flange face 94, stage 12, workpiece biasing 90 and the gas outlet 10. In the example, the lower flange face 94 is connected to the ground. The conductive structure 16 and inductor winding 4 extend substantially throughout entire height of the cylinder 2.

The top of the quartz cylinder 2 is closed by a conductive target plate 100 that constitutes an ion source. The conductive target plate 100 is mounted and sealed to the cylinder 2 via a peripheral connecting flange 102. A radio frequency (RF) generator such as a magnetron 104 is mounted on the top of the conductive plate 100 and has its cathode electrically connected to the latter to form a sputtering target that produces a flux of metal ions.

The apparatus thereby uses the conductive structure 16 and the inductor winding 4 as a means for re-ionising a flux of metal ions produced by an independent source, in this case the magnetron 104.

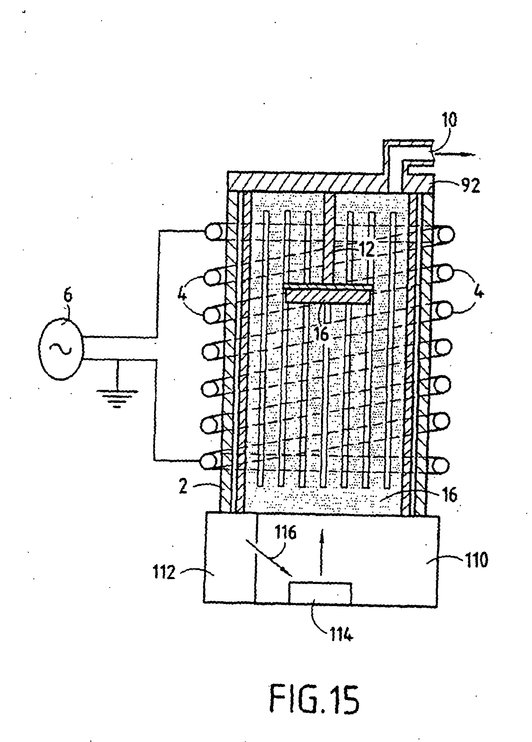

Figure 15 shows another embodiment of a plasma processing chamber in accordance with the present invention also designed to function as reactor for the re-ionisation of metal ions e.g. for ion sputtering applications, but using as an ion source the evaporation of a solid by an electron beam to form an ion flux.

The plasma processing chamber 2 is similar to the one described with reference to figure 14 except that it is provided with a top flange face 92 as in the embodiment of figure 13, and that the bottom of the chamber is attached to an electron beam evaporator. The workpiece 16 is held suspended from a stage 12 depending from the top flange face 92.

The bottom portion of the chamber 2 comprises a casing 110 whose internal space communicates with the chamber 2 and encloses an electron beam source 112 and a metal or oxide target 114.

The electron beam source 114 is arranged to direct an electron beam 116 to the target 114 to vaporise the latter at a predetermined rate. The vapour is then brought into the chamber 2, either by natural convection or by an accelerating electrode (not shown), and thereby made to react with induced field to form a plasma.

The present invention can be implemented in many other forms than those just described.

For instance, the process chamber need not be cylindrical, but can have any appropriate shape according to applications and design practice. The shape of the conductive structure will then be adapted correspondingly.

While the problem of unwanted coating of a conductive film on the inner face of the process chamber occurs essentially when the chamber is used with reaction gases containing conductive materials for depositing on a workpiece, the present invention can of course also be used in plasma processing apparatus for all types of surface processing, such as for deposition of insulating and semiconducting materials or for etching.

### Description For the Following contracting states: CH, DE, FR, GB, IT, LI, NL

The present invention generally relates to the field of plasma surface treatment and, more particularly, to a process chamber for such purposes. The invention also relates to a plasma processing apparatus implementing the aforementioned process chamber and to its use for plasma processing.

The plasma treatment envisaged by the present invention is not limited to specific applications or techniques. Examples of applications in this field notably include plasma enhanced chemical vapour deposition (PECVD), also known as plasma assisted chemical vapour deposition (PACVD).

Chemical vapour deposition (CVD) in general is a technique for treating a surface of a workpiece, e.g. a substrate, by immersing the latter in a precursor gas or precursor gas mixture of selected materials within a process chamber. The materials in gaseous form, known as active species, can be deposited on the workpiece surface under controlled conditions (gas composition, pressure and temperature, and surface temperature, etc.). The composition of the immersing gas can also be chosen to etch away the surface of the workpiece at chosen areas using a mask.

Classical CVD generally requires the workpiece to be kept at a fairly high temperature to initiate and sustain the deposition of a film thereon, being essentially a thermally-driven process. It works satisfactorily (ignoring some more specific issues such as thermal stress) all the while the substrate can withstand the temperature that makes the process economically viable.

When this condition cannot be met, it is usual to overcome the temperature limitation by resorting to PECVD, which involves creating a plasma inside the process chamber to enhance vapour deposition (this technique is also known as plasma-assisted chemical vapour deposition (PACVD)).

The species generated by a plasma are characteristically different from those contained merely in the gas phase of the same precursor species used in classical chemical vapour deposition. This can be explained by the fact that plasma is intrinsically a medium in thermodynamic non-equilibrium. Although the actual phenomena that occur in a plasma are extremely complex, it can be said that, in general, the purely thermal activation of a classical CVD reaction generated by a high substrate temperature can be switched to the plasma phase in which the active species are pre-cracked in the plasma instead of being cracked only at the level of the hot substrate surface. Consequently, plasma-enhanced CVD allows a dramatically lower substrate temperature than with gaseous CVD for. comparable film deposition characteristics.

PECVD is nowadays used extensively in the field of surface engineering, e.g. for etching or deposition of various materials. It offers levels of performance unattainable by the other, more classical techniques.

Figure 1 illustrates very schematically the main parts of a classical PECVD apparatus in which a plasma in generated by inductive coupling, currently one of the most versatile and reliable method of plasma generation for industrial applications.

The apparatus comprises a cylindrical reaction vessel 2 made of dielectric material, such as a quartz, surrounded by a radio-frequency (RF) inductor in the form of a helical electrode 4 connected to an RF energy source 6. When activated, the electrode 4 induces an RF electromagnetic energy field inside the reaction vessel 2 such as to create a plasma with the precursor gases by RF coupling.

In order to establish the gas conditions, the vessel 2 comprises a number of inlets 8 for controllably admitting the precursor gas or gases. It is also has an outlet 10 connected to an exhaust pump (not shown) to establish the required low pressure conditions and to evacuate used reaction gases.

A stage 12 having a T-shaped cross-section is provided in the vessel 2 for supporting a workpiece 14 at an optimum position within the plasma.

For the sake of simplicity, the means for accessing the chamber and handling the workpiece are not shown nor discussed, these being well-known in the art.

In operation, a workpiece 14 - which can be an insulator, semiconductor or conductor - is introduced onto the stage 12. The vessel 2 is then evacuated to a pressure corresponding to a partial vacuum, and a precursor gas or gas mixture is introduced through the inlets 8. The precursor gas used contains atoms or molecules of the material to be deposited in a form that can be liberated by the plasma in the process chamber 2, and is often admixed with deposition-enhancing components. The deposited material can be insulating or electrically conductive.

The RF energy source 6 is activated so as to induce a plasma of appropriate characteristics within the vessel. The plasma in the chamber breaks down the gas into its precursor species, which are then deposited in a controlled manner on the surface of the workpiece to form a layer of material corresponding to the precursor.

A problem arises with this type of apparatus when used for depositing layers of electrically conductive material. In this case, some of the atoms or molecules of the precursor gas containing the conductive material tend to migrate to the internal surface of the chamber walls and, over time, form a conductive film thereon. The conductive film tends to screen out the electromagnetic energy delivered by the RF inductor electrode 4. This phenomenon subsequently makes it impossible to sustain a plasma inside the process chamber, the electromagnetic energy being absorbed by the electrically conductive film instead of the plasma itself. The industrial consequence is a drift in the process performance and frequent downtime for cleaning the chamber walls.

To overcome this problem, some forms of PECVD apparatus have the inductor electrode contained inside the process chamber itself, so that the inner surface of the chamber walls is outside the RF energy field and hence outside the space occupied by the plasma.

Such an apparatus is illustrated very schematically in figure 2, where elements corresponding to those of figure 1 are identified by like references and shall not be discussed further in any detail. The RF inductor electrode 4 has a plate-like structure and is installed inside the process chamber 2, above the stage 12. The latter can be isolated or biased to establish and maintain the plasma.

An example of such an apparatus is disclosed in document EP-A-0 424 620.

However, this approach brings problems of its own, including :
- the material of the RF electrode, being immersed in the plasma and reaction gas environment - at least at the level of its exposed surface - becomes a source of uncontrollable contamination, notably through sputtering by high-energy particles in the plasma, and
- the RF electrode additionally generates a very high and uncontrolled electric field within the plasma, which can create non-uniformities over the deposition surface.

Documents US-A-4 795 879, US-A-5556521 and EP-A-0 782 172 show examples of plasma processing apparatuses. Documents EP-A-0 801 413 and WO-A-98 48444, which constitute prior art according to Article 54(3) EPC, describe plasma chambers comprising conductive means arranged within plasma chambers, said conductive means comprising one or a plurality of slits to interrupt circumferential currents. characterised in that the conductive means comprises at least one conductive element in physical contact with the internal surface.

An object of the present invention is to overcome the problem of unwanted film deposition on the inner surface of the process chamber without resorting to provide the inductor electrode inside the chamber.

The process chamber envisaged by the invention is bounded by wall portions and adapted to receive electromagnetic energy by inductive coupling from an external inductor connected an ac supply, to create, enhance or sustain a plasma therein, the chamber comprising conductive means arranged within said chamber to confront at least a part of the internal surface of the wall portions such as to inhibit coating thereon of material evolved from plasma processing, characterised in that the conductive means comprises at least one conductiv element in physical contact with the internal surface.

The conductive means thus effectively constitutes a trap for condensing conductive material particles in the plasma before they can reach the inner surface of the wall portions.

Over time, the film of conductive material that would otherwise be formed on the inner wall portions of the process chamber accumulates instead on the conductive means. However, this accumulation is not detrimental since it forms on surfaces which are already electrically conductive.

In preferred embodiments of the invention, the conductive means comprise a conductive structure having an outer surface that follows an internal contour of at least part of the wall portions of the process chamber.

The conductive means has at least a substantial portion thereof in physical contact with the internal surface of the chamber.

The outer surface of the conductive structure can be configured to follow a substantial proportion of the wall portions. In this case, it may comprise one or more apertures to allow the passage of electromagnetic energy into the chamber.

The presence of one or more apertures in the case where the conductive means constitutes, to some extent at least, a Faraday cage can produce two significant effects.

Firstly, the aperture(s) (e.g. in the form of slits) divide the conductive means into a plurality of sectors, each sector being a portion of contour of the conductive means. In the presence of the plasma-inducing electromagnetic field, these sectors serve as intermediate inductors in accordance with Lenz's law. Basically, the conductive means can be considered as being placed in an inductor having a current lind flowing therethrough. The inductor generates a magnetic field in all the environing space, giving rise to flux variations in the conductive means. The conductive means tends to cancel these flux variations by creating its own induced currents.

This phenomenon takes place between the inductor and each sector of the conductive means forming a Faraday cage. Induced currents created within each sector themselves create currents that are induced into the plasma.

The presence of one or more apertures can prevent such induced currents from forming loops extending around the entire periphery of the conductive means, and which would otherwise tend to short-circuit the magnetic field.

Secondly, the aperture(s) help to enhance the passage of electromagnetic energy into the process chamber.

Because the conductive material particles accumulate on the conductive surface of the structure, the apertures remain clear even after prolonged use. There is thus no drift in the performance characteristics of the process chamber over time.

The apertures may be in the form a series of slits following an arbitrary pattern.

The apertures can be configured to define an indirect path for the electromagnetic energy from the inductor to inside the chamber. In other words, the configuration of apertures is such that it does not allow a direct line of view into the chamber from the outside.

If the process chamber has a regular geometry and the RF electromagnetic energy is to be present homogeneously inside, the apertures are preferably distributed uniformly over the conductive means.

In a preferred embodiment, the conductive means comprises a series of conductive elements dependent from a mechanical support means and distributed so as to form an array that confronts the internal surface of the chamber. In this case, the aforementioned apertures can be advantageously defined by spaces separating neighbouring conductive elements.

The conductive elements can be profiled so as to overlap in a non-contacting manner with neighbouring conductive elements in order to define the indirect path for the energy field.

The conductive elements can also be imbricated in a non-contacting manner with their neighbouring conductive elements at confronting edges to define the indirect path.

The conductive elements can conveniently be constructed as a series of elongate rectangular panels whose major length extends parallel to a principal axis of the process chamber.

In embodiments of the invention in which the conductor means is in physical contact with the internal wall of the chamber, the conductor means can be mechanically biased against that internal wall, e.g. by resilient mounts provided at the level of the mechanical support.

In a classical application, the conductive means bounds a space inside the chamber, within which a plasma condition is to be created. This space may include the space containing the workpiece to be received or it may be outside the workpiece. The latter possibility can be chosen e.g. for deposition of a material at a post plasma discharge position of the chamber. In this case, an inlet may be provided for reaction material, e.g. a gas or gas mixture, outside the space bound by the conductive means.

It is also possible according to the present invention to dispose of a source of plasma material, such as an ion source, within the chamber itself.

Advantageously, the source of plasma material can be constituted by the conductive means itself. Thus, in addition to protecting the wall portions of the chamber, the conductive means can also serve e.g. as a source of metal ions for plasma deposition. To this end, the conductive means is composed - at least in part - of the material(s) constituting the desired deposition. The conductive means can thus be activated by being connected to a dc or ac source (including radio frequencies) to activate particle sputtering from its constituant material(s).

The ions freed in this way are re-ionised by the induced plasma created by ionised gases through the induced energy field.

It has been found by the applicant that the source of plasma material can thereby be stronger by comparison with techniques based on the admission of the material in gaseous form.

Moreover, this technique makes it possible to create a reactive plasma whilst obviating the need to use a dangerous gas. For instance, a conductive means made - at least in part - of tungsten can replace the use of a tungsten hexafluoride (WF₆), which, being a fluourised gas, is potentially hazardous.

The use of the conductive means as an ion source is possible in embodiments where the workpiece is immersed in the induced energy field, i.e. where the conductive means would thereby preferably bound a space containing the workpiece, as well as where the workpiece is outside that space, for a post plasma discharge deposition.

The source of plasma material inside the chamber can also comprise a cathode associated with an electrical energy source, such as a magnetron. The cathode can conveniently be provided at an end portion of a space bound by the conductive means, for instance at one end of the plasma processing chamber.

The ion source may also comprise a source of metallic vapour and activating means, such as an electron (or other particle) beam generator for transmitting energy to vaporise that source.

It has been found that the effectiveness of the conductive means can be greatly enhanced if it is cooled, e.g. by a fluid flow.

To this end, the conductive means can comprise a conduit arrangement for allowing a flow of thermal fluid and connected to a cold source for ensuring cooling thereof.

Depending on operating conditions (plasma characteristics, precursor gases, etc.) the efficiency of the conductive means can also be improved if means are provided for electrically biasing them with an ac voltage (including an RF voltage) or a dc voltage (including ground).

In this case, the conductive means can be divided into two or more isolated sections, the biasing means being operative for biasing the sections separately.

The conductive means can further comprise a window portion to enhance plasma ignition.

The window can be associated with shutter means for adjusting the degree of opening of the window.

If needs be, the process chamber can comprise a workpiece-supporting stage which is connectable to a biasing source to bias a workpiece on the stage, either directly or via a temperature-controlled susceptor, with an ac voltage (including an RF voltage) or a dc voltage (including ground).

The process chamber can further comprise a sputtering target.

The present invention also concerns a plasma processing apparatus, e.g. for plasma enhanced chemical vapour deposition or plasma processing by re-ionisation, comprising :
- a process chamber based on the conductive means as precedingly defined,
- an electromagnetic energy inductor for delivering electromagnetic energy to the process chamber, and
- an energy source for driving the inductor.

Depending on the embodiments, the apparatus may also comprise biasing means for biasing the conductive means with an ac voltage (including an RF voltage) or a dc voltage (including ground).

These biasing means can comprise means for independently biasing the two or more isolated sections of the conductive means, if the latter is so configured.

Finally, the present invention also concerns the use of plasma processing apparatus as defined above for :
depositing a conductive film on a substrate,
ion etching on a substrate, or
processing a workpiece by re-ionisation, the ion source being either the conductive means itself, a cathode or a vaporisable source, or indeed any other appropriate source.

The invention will be better understood from the following description of preferred embodiments, given strictly as non-limiting examples, with reference to the appended drawings in which :
- figure 1 is a highly simplified sectional view of a classical PECVD apparatus with RF coupling of the electromagnetic energy field through the process chamber;
- figure 2 is highly simplified sectional view of a prior art PECVD apparatus with the electromagnetic energy field generated within the process chamber;
- figure 3 is a simplified general view of a an example of a PECVD apparatus according to a first embodiment of the present invention;
- figure 4a is a plan view of an aperture pattern formed by a conductive structure used in the apparatus of figure 3;
- figure 4b is a partial perspective view of the conductive structure shown in figure 4a;
- figure 5a is a partial perspective view of an aperture pattern formed by a conductive structure used in the apparatus of figure 3;
- figure 5b shows a detail of the conductive structure shown in figure 5a;
- figure 6a is a partial perspective view of an aperture pattern formed by a conductive structure used in the apparatus of figure 3;
- figure 6b shows a detail of the conductive structure shown in figure 6a;
- figure 7 is a perspective view of the conductive structure and mount therefor according to a first embodiment of the invention;
- figure 8 is plan view of a conductive structure and mount therefor according to a first variant of the first embodiment;
- figure 9 is a plan view of a conductive structure and mount therefor according to a second variant of the first embodiment;
- figure 10 is a plan view of a conductive structure and mount therefor according to a third variant of the first embodiment;
- figure 11a is a general view of the conductive structure of figure 3 equipped with a cooling system;
- figure 11b is a partial plan view of the conductive structure of figure 11a and its positioning with respect to the process chamber;
- figure 12 is a general view of a variant of the conductive structure shown in figure 10;
- figure 13 is a simplified view of a plasma processing chamber adapted for processing a workpiece at a post plasma discharge position, according to a second embodiment of the invention;
- figure 14 is a simplified view of a plasma processing chamber implemented for ion flux re-ionisation by means of an internal sputtering target; and
- figure 15 is a simplified view of a plasma processing chamber implemented for ion flux re-ionisation by means of an internal electron beam evaporator.

A PECVD apparatus is shown in figure 3. For simplicity and conciseness, the parts of this apparatus which are analogous to those of figures 1 and 2 are given the same reference numerals and their functional role shall not be repeated.

In the example, the process chamber 2 is generally cylindrical, with its curved wall portion made of a dielectric material such as quartz. Because the dielectric material is transparent to the radio frequencies used, the electromagnetic energy generated by the RF energy source 6 is transmitted directly from the inductor electrode 4 through to the interior of the process chamber 2. In some other types of process chamber envisageable with the invention, the walls may be made largely of conductive material, in which case a dielectric window needs to be formed on one or several parts of the walls to allow adequate RF transmission from the inductor electrode 4 to the interior of the process chamber.

The top wall 2a and bottom wall 2b of the process chamber are made of stainless steel, and respectively include a reaction gas inlet 8 and an exhaust outlet 10.

The process chamber 2 also comprises means for maintaining a workpiece 14 inside the plasma environment. In the example, the workpiece 14 (e.g. a substrate) is held in suspension at a central position of the process chamber, e.g. by cables (not shown). Alternatively, the process chamber can be provided with a stage, as shown in the examples of figures 1 and 2, or any other known supporting structure.

If the process chamber 2 has a stage, the latter can be connected to a biasing source (not shown) to bias the workpiece (e.g. a substrate), either directly or via a temperature-controlled susceptor. For biasing, an ac voltage (including an RF voltage) or a dc voltage (including ground) may be used.

The process chamber 2 contains an electrically conductive structure 16. Its purpose is to inhibit the deposition of conductive vapour deposition material on the inner surface of the walls of the process chamber 2.

A biasing source 7 is connected to the conductive structure to bring the latter to a dc or ac potential (including radio frequencies) or to provide a ground connection, according to implementation of the apparatus and the mode of operation.

The conductive structure 16 is generally cylindrically shaped and positioned close to and concentrically with the cylindrical chamber wall. It is made from sheet metal, such as copper, having sufficient thickness to ensure minimal distortion under its own weight and over the temperatures existing inside the process chamber 2.

The radial separation d between the inner surface of the chamber wall and the outer surface of the conductive structure 16 is chosen such that no plasma is created between these two surfaces. The appropriate value of this separation d can be determined analytically using Paschen's law of ionisation in gases, or empirically. This value is a function of the chamber geometry, design of the conductive structure, frequency and intensity of the RF energy, as well as gas composition and pressure.

In the example based on a cylindrical, quartz process chamber operating at a pressure on the order of 100 milli Torr (converted as 13.3 Pa), it has been found that excellent results can be obtained for a large variety of gases with the separation d kept to 1mm or less.

The conductive structure 16 can be held in position within the process chamber 2 by any suitable means. In order to ensure that the separation d is maintained accurately with respect to the cylindrical chamber 2, the inner wall of the latter can be provided with a series of ribs (not shown) projecting inwardly by an amount corresponding to the separation d. The outer surface of the conductive structure 16 is then held in abutment against the ribs, either by elasticity of its constituent material, or by mechanical mounts, adhesives or the like. The fixing of the conductive structure 16 inside the process chamber 2 may not necessarily be permanent. It is possible to make the conductive structure detachable from the process chamber to allow easy access both to the chamber itself, e.g. for insertion/removal of workpieces and to the conductive structure, e.g. for cleaning.

In order to allow adequate transmission of the RF energy into the process chamber 2, the conductive structure 16 is provided with a series of apertures formed uniformly over its surface. In the example of figure 3, the apertures are in the form of slits 18 that extend parallel to the principal axis of the conductive structure 16. The slits can of course be arranged to extend along other directions, e.g. obliquely with respect to the main axis of the process chamber. They can be continuous or divided into length segments over their path. The latter possibility can be chosen if required to make the conductive structure more rigid. In the example, the area occupied by the apertures corresponds to around e.g. 5 to 35 % of the total surface of the conductive structure. However, these values are only indicative; the area occupied by the apertures and their configuration can be adapted to design criteria for suitably diminishing losses and induced currents as explained above.

The slit-like apertures 18 in figure 3 are formed by cut-outs, corresponding to the slits, formed along length portions of a closed cylinder. The shielding means thereby has an integral structure.

Alternatively, the shielding means can have a composite structure as shown in figures 4a and 4b. In the illustrated example, it is composed of upper and lower support rings 50 (only the upper ring is shown in the figures) to which are fastened the respective ends of a series of elongate metal panels 52. The series of metal panels 52 extends around the circumference of the support rings 50, each panel having straight longitudinal edges 54 and being separated from its neighbour by a small gap 56. The height (axial length) of the support rings is preferably made as small as possible in order to maximise the effective length of slits and thereby also to maximise the axial length portion of the conductive means that is effective for inductive coupling. The width and the pitch of the gaps 56 is such as to provide a series of openings corresponding in form and function to the slits 18.

Two variants of the above composite structure are shown in figures 5a, 5b and 6a, 6b, respectively. In these two variants, the metal panels 52 have profiled edge portions such as to allow an imbrication between neighbouring panels. This arrangement ensures that the panels 52 occupy the entire perimeter of the shielding means 16, leaving no straight passages for lines directed along a radial direction with respect to the principal axis. The imbricated portions of neighbouring panels are not contiguous, being separated by a predetermined gap which forms a labyrinthine passage for the field from the inductor 4 to the process chamber 2. In this way, the imbrication of the panels eliminates direct lines of view between the plasma and the dielectric chamber.

In figures 5a and 5b, each of the two longitudinal edges of the panels 52 defines a step 58 and 60 so as to present a face 58a and 60a turned respectively outwardly and inwardly relative to the principal axis of the conductive structure. The panels 52 are relatively positioned at their edges so that an inwardly turned face 60a confronts an outwardly turned face 58a, thereby forming an imbrication of the panels 52 around a complete closed path. The overlapping step portions 58, 60 of neighbouring panels 52 are separated from each other by a predetermined space 62 to create the aforementioned gap. The passage for the field thereby defined by the space 62 follows round the confronting step portions 58, 60.

In figures 6a and 6b, the two edges of the panels respectively define an elongate tongue 64 and an elongate groove 66 adapted to receive a corresponding tongue. Both the tongue 64 and the groove 66 extend along the respective edges of the panel 52. The panels 52 are assembled to form a complete closed path, with the tongue 64 at the edge of one panel 52 received in the groove 66 of the neighbouring panel. The grooves 66 have a width w exceeding the thickness t of the tongues 64, and the tips 64a of the tongues are recessed from the bottom 66a of the groove to create an intermediate space 62 that defines the aforementioned gap. The passage for the field defined by the gap thus follows round the internal surfaces of each groove 66.

The examples illustrated in figures 3 to 6 show the conductive structure separated from the internal wall of the plasma processing chamber 2 by a small distance d. An alternative arrangement shall now be described with reference to figure 7, in which the conductive structure is instead in physical contact ~ at least at major portions thereof - with the internal wall of the chamber 2.

The conductive structure is constructed in a manner similar to that described with reference to figures 4a and 4b as far as the general configuration of the conductive panels 52 and their disposition are concerned. However, the panels 52 are in this case mounted on upper and lower support rings 50 through resilient mounts adapted to press the panel 52 radially outwardly against the inner wall of the chamber 2. Each mount 68 comprises a stem portion 70 attached to the support ring 50 and projecting radially outwardly from the latter. A compression coil spring 72 is engaged axially with the stem 70 such that its respective ends press against the support ring 50 and the inner face of the conductive panel 52. Similar resilient mounts 68 are provided at the lower ring and, if necessary also at one or several intermediate support ring(s).

The resilient mounts 68 are adapted to provide sufficient pressure to ensure a good contact of the panels 52 with the internal surface of the chamber 2 over the thermodynamic cycles experienced in use. The differential expansion coefficients between the chamber wall and the conductive panel structure are absorbed by the resiliency of the mounts, resulting in no significant distortion of the conductive structure or excessive stress on the chamber wall.

Figures 8 and 9 show the arrangement of the resilient mounts described with reference to figure 7, adapted to support the conductive panels with profiled edges shown in figures 5a and 6a respectively, imbricated to prevent a direct view to the chamber from the outside. Here, as in figures 5 and 6, the profile features and the gaps created therebetween are formed in the thickness of the panels.

Figure 10 shows a variant in which the edge profiles of the panels are formed instead by folding the panel-forming material. In the example, only one panel 52b in two is profiled, the profiled panels being arranged in alternation with straight panels 52a so as to form a closed path. The profiled panels 52b have at each of their edges two longitudinal right-angle folds 72a and 72b so as to form a wing 74 in a plane parallel to that of the main, central portion of the panel and radially inwardly displaced with respect to the latter. Each wing 74 thereby overlies an edge portion of a neighbouring, non-profiled panel. The width and amount of inward radial displacement of the wings 74 determine the size and shape of the gap 62 between neighbouring panels 52a, 52b that forms the labyrinthine path for the field.

It will be apparent that there are many possible ways of folding the edges of the conductive panels to form imbrications to avoid a direct view across the conductive structure whilst allowing the passage of energy field.

The conductive structure 16 is shown to be electrically grounded in the PECVD apparatus of figure 3.

However, it is also envisageable to provide means for biasing the conductive structure 16 with an ac voltage (including an RF voltage) or a dc voltage. In this case, the conductive structure can be divided into two or more isolated sections, each receiving an independent bias voltage from a respective biasing source. In the embodiments based on a composite structure, the panels 52 can conveniently be biased individually or in small groups. In this case, the resilient mounts 68 or direct connections to the upper and lower support rings 50 can be electrically insulated and provided with appropriate contact means for connection to a biasing source.

Figure 11 shows the conductive structure 16 implemented in the apparatus of figure 3, additionally provided with a cooling arrangement. The cooling arrangement comprises fluid conduits 24 incorporated into the conductive structure 16 and communicating through an inlet 26 and an outlet 28 with a fluid cooler 30 and a pump 32 in a closed system. The cooling fluid used can be water, possibly with some additives, oil or any other liquid. Cooling may also be effected by forced air passing through the conduits 24.

The incorporation of the fluid conduits 24 into the conductive structure 16 is shown in more detail in figure 11a. The fluid conduits 24 are formed by narrow, profiled metal strips 34 that run along a substantial portion of the axial length of the conductive structure 16. In the example, there is provided a conduit 34 between each pair of slits 18. The strips have a tab portion 34a at each longitudinal edge and an arcuate portion 34b between the tab portions. The tab portions 34a are sealingly attached, e.g. by welding, to the inner surface of the conductive structure at a region between the slits 18 and parallel to the latter. The arcuate portion 34b of the strip creates a channel 36 with the confronting inner surface of the conductive structure 16, allowing passage of the cooling fluid.

The metal strips 34 are interconnected at end portions of the conductive structure so that their respective channels form a continuous serpentine conduit configuration between the fluid inlet 26 and outlet 28.

It can be noted that with this construction, the cooling system forms an integral part of the conductive structure, being in direct physical contact with the cooling fluid. The heat generated at the structure is thereby evacuated very efficiently. Moreover, the strips 34 create negligible shadowing of the apertures (in this case formed by the slits 18).

The above-described conduits can of course be implemented with a conductive structure shown in figures 4a to 10, or indeed any other type of aperture configuration.

Alternatively, the conduits can be implemented by an arrangement of pipes and radiator fins attached to the conductive structure in accordance with standard practices for heat sinks.

It has been found by the applicant that by maintaining the conductive structure cool, the deposition rate of conductive material onto its inner surface is reduced dramatically.

Figure 12 shows a variant of the conductive structure described with reference to figure 11 that features an adjustable window to help establish plasma electrostatic ignition.

The window 38 comprises a cut-out portion of the conductive structure 16 located e.g. mid-way between the ends of the latter and occupying e.g. 10 to 25% of its circumference. The window area is selectively adjustable between open and closed states by means of a pair slidable conductive shutters 40. The shutters 40 follow the contour of the conductive structure 16 and are mounted on the inner face of the latter so as leave the free the small separation d between the outer face of the conductive structure and the inner face of the reaction chamber wall. Each shutter 40 is slidable, either manually or by a remote control mechanism (not shown) in a circumferential direction to close a selected portion of the window cut-out 38.

The apertures in conductive structure 16, whether they be slits 18 or elementary cut-outs 20 or 22 stop short of the boundaries of the window area 38 to allow the passage and interconnection of the cooling conduits 24 around that area.

Although only one window cut-out 38 is shown in the figure, it can be envisaged to provide several windows for the same purpose. The windows may be distributed around the circumference of the conductive structure and/or superposed along the principal axis of the latter.

It should be noted that the conductive structure in all of the embodiments described can be further provided with additional apertures for allowing access to the process chamber.

Figure 13 shows another embodiment of a plasma processing chamber 2 in accordance with present invention which differs from the one of figure 3 essentially in that the conductive structure 16 and inductor winding 4 are present only at a top portion of the chamber 2, above a stage 12 for supporting a workpiece 16. The stage 12 is connectable to a dc or ac source 90 to bias the workpiece thereon. This arrangement allows material deposition or other forms of processing to be effected on the workpiece under post plasma discharge conditions.

The conductive structure is connected to a biasing source 7 as in the embodiment of figure 3.

In the example, the reaction chamber comprises a quartz cylinder 2 terminated at each end respectively by upper and lower flange faces, 92 and 94. The conductive structure 16 - which can adopt any of the forms described with reference to figures 3 to 12 - is suspended from the top flange face 92.

The process gas or gas mixture is introduced from an inlet 8 formed in the quartz cylinder 2 between the bottom of the conductive structure 16 and the stage 12. It is also envisageable to provide injection from the upper part of the reaction chamber. Vacuum pumping of the chamber is effected through an outlet 10 at the lower flange face.

In the embodiments of plasma processing chamber described above, the reactive material is introduced in gaseous form from outside the chamber through an inlet.

However, the conductive means 16 can serve as a source of reactive material in addition to the function of preventing unwanted deposition on the internal walls of the chamber. In this case, the material of the conductive means is chosen to contain - either wholly or in part - the constituent to serve as a material to be deposited on the workpiece. All conductive structures described above can be made to provide this additional function.

The means for implementing the processing chamber according this aspect of the present invention are basically identical to those described above and will therefore not be repeated for conciseness. The conductive structure biasing source 7 is in this case adapted to provided a suitable bias to cause sputtering from the conductive structure. The bias can be a dc or an ac signal.

Depending on applications, the substrate holder 12 - and hence the workpiece 14 - can be biased to ensure optimal conditions.

Many materials can be chosen for constituting - or for incorporation into-the conductive structure. For example, the material can be tungsten for depositing tungsten material on the workpiece 14. In this manner, the use of the conductive structure 16 as an ion source obviates the classical requirement of introducing tungsten hexafluoride into the chamber 2.

Figure 14 shows another embodiment of a plasma processing chamber in accordance with the present invention, designed to function as a reactor for the re-ionisation of metal ions e.g. for ion sputtering applications. Its construction is similar to that of figure 13 at the level of the quartz cylinder 2, lower flange face 94, stage 12, workpiece biasing 90 and the gas outlet 10. In the example, the lower flange face 94 is connected to the ground. The conductive structure 16 and inductor winding 4 extend substantially throughout entire height of the cylinder 2.

The top of the quartz cylinder 2 is closed by a conductive target plate 100 that constitutes an ion source. The conductive target plate 100 is mounted and sealed to the cylinder 2 via a peripheral connecting flange 102. A radio frequency (RF) generator such as a magnetron 104 is mounted on the top of the conductive plate 100 and has its cathode electrically connected to the latter to form a sputtering target that produces a flux of metal ions.

The apparatus thereby uses the conductive structure 16 and the inductor winding 4 as a means for re-ionising a flux of metal ions produced by an independent source, in this case the magnetron 104.

Figure 15 shows another embodiment of a plasma processing chamber in accordance with the present invention also designed to function as reactor for the re-ionisation of metal ions e.g. for ion sputtering applications, but using as an ion source the evaporation of a solid by an electron beam to form an ion flux.

The plasma processing chamber 2 is similar to the one described with reference to figure 14 except that it is provided with a top flange face 92 as in the embodiment of figure 13, and that the bottom of the chamber is attached to an electron beam evaporator. The workpiece 16 is held suspended from a stage 12 depending from the top flange face 92.

The bottom portion of the chamber 2 comprises a casing 110 whose internal space communicates with the chamber 2 and encloses an electron beam source 112 and a metal or oxide target 114.

The electron beam source 114 is arranged to direct an electron beam 116 to the target 114 to vaporise the latter at a predetermined rate. The vapour is then brought into the chamber 2, either by natural convection or by an accelerating electrode (not shown), and thereby made to react with induced field to form a plasma.

The present invention can be implemented in many other forms than those just described.

For instance, the process chamber need not be cylindrical, but can have any appropriate shape according to applications and design practice. The shape of the conductive structure will then be adapted correspondingly.

While the problem of unwanted coating of a conductive film on the inner face of the process chamber occurs essentially when the chamber is used with reaction gases containing conductive materials for depositing on a workpiece, the present invention can of course also be used in plasma processing apparatus for all types of surface processing, such as for deposition of insulating and semiconducting materials or for etching.

## Claims (Claims for the following Contracting State(s): AT, BE, DK, ES, FI, GR, IE, LU, PT and SE)

1. A process chamber (2) for a plasma processing apparatus, said chamber being bounded by wall portions and adapted to receive electromagnetic energy by inductive coupling from an external inductor (4) connected to an ac supply (6), to create, enhance or sustain a plasma therein,
said chamber comprising conductive means (16) arranged within said chamber (2) to confront at least a part of the internal surface of the wall portions such as to inhibit coating thereon of material evolved from plasma processing,
**characterised in that** said conductive means is arranged at a distance of less than 10 mm from said internal surface.

2. The process chamber according to claim 1, wherein said distance is less than 1 mm.

3. The process chamber according to claim 2, wherein said conductive means (16) comprises at least one conductive element (52) in physical contact with said internal surface.

4. The process chamber according to claim 3, wherein said at least one conductive element (52) is pressed against said internal surface through resilient mount means (68).

5. The process chamber (2) according to claim 3 or 4, wherein said at least one conductive element (52) consists of a series of conductive elements (52) dependent from a mechanical support means (50) and distributed so as to form an array that is in physical contact with said internal surface.

6. The process chamber (2) according to claim 5, wherein said conductive elements are in the form of elongate rectangular panels (52) whose major length extends parallel to a principal axis of the process chamber (2).

7. The process chamber (2) according to any one of claims 1 to 6, wherein said conductive means (16) comprises at least one aperture (18; 56; 62) for allowing the passage of electromagnetic energy into said process chamber.

8. The process chamber (2) according to claim 7, wherein said apertures(s) (18; 56; 62) are arranged so as to break down circulating currents induced in said conductive means (16) into plural current loops.

9. The process chamber (2) according to claim 7 or 8, wherein said apertures form a series of slits (18).

10. The process chamber (2) according to any one of claims 7 to 9, wherein said apertures (62) define an indirect path for the electromagnetic energy from the inductor to inside the chamber.

11. The process chamber (2) according to any one of claims 7 to 10, wherein said apertures (18; 56; 62) are distributed uniformly over said conductive means (16).

12. The process chamber (2) according to any one of claims 7 to 11 when dependent on claim 5 or 6, wherein said apertures are defined by spaces (56; 62) separating neighbouring conductive elements (52).

13. The process chamber (2) according to claim 12 when dependent on claim 10, wherein said conductive elements (52a) are profiled so as to overlap in a non-contacting manner with neighbouring conductive elements in order to define said indirect path (figure 10).

14. The process chamber (2) according to claim 12 when dependent on claim 10, wherein said conductive elements (52) are imbricated in a non-contacting manner with their neighbouring conductive elements at confronting edges to define said indirect path (figures 8, 9).

15. The process chamber (2) according to any one of claims 1 to 14, wherein said conductive structure (16) bounds a space inside said chamber within which a plasma condition is to be created.

16. The process chamber (2) according to claim 15, wherein said space includes a space within which a workpiece (16) is to be received.

17. The process chamber (2) according to claim 15, wherein said space is outside a space within which a workpiece (16) is to be received.

18. The process chamber (2) according to claim 17 comprising an inlet (8) for reaction material e.g. a gas or gas mixture outside said space bound by said conductive means (16).

19. The process chamber (2) according to any one of claims 1 to 18, containing an ion source (16; 100, 104; 110) therewithin.

20. The process chamber (2) according to claim 19, wherein said conductive means (16) constitutes said ion source.

21. The process chamber (2) according to claim 20, wherein said conductive means (16) is connectable to an electrical energy source (7) to form an ion sputtering source.

22. The process chamber (2) according to claim 19 or 20, wherein said conductive means (16) is made at least in part of a material comprising the material to be coated.

23. The process chamber (2) according to claim 19, wherein said ion source comprises a cathode (100) associated with a magnetron (104).

24. The process chamber (2) according to claim 23, wherein said cathode (100) is provided at an end of portion of a space bound by said conductive means (16).

25. The process chamber (2) according to claim 19, wherein said ion source comprises a source (114) of metallic vapour and activating means (112) for transmitting energy to vaporise said source.

26. The process chamber (2) according to claim 25, wherein said activating means (112) comprises a particle beam generator, e.g. an electron beam generator.

27. The process chamber (2) according to any one of claims 1 to 26, wherein said conductive means (16) is cooled by a fluid flow.

28. The process chamber (2) according to any one of claims 1 to 27, further comprising biasing means for electrically biasing said conductive means (16) with an ac voltage (including an RF voltage) or a dc voltage (including ground).

29. The process chamber (2) according to claim 28, wherein said conductive means (16) is divided into two or more isolated sections, said biasing means being operative for biasing said sections separately.

30. The process chamber (2) according to any one of claims 1 to 29, wherein said conductive means (16) further comprises at least one window portion (38) to enhance plasma ignition.

31. The process chamber (2) according to claim 30, further comprising shutter means (40) for adjusting the degree of opening of said window (38).

32. The process chamber (2) according to any one of claims 1 to 31, further comprising a workpiece-supporting stage which is connectable to a biasing source to bias a workpiece on said stage, either directly or via a temperature-controlled susceptor, with an ac voltage (including an RF voltage) or a dc voltage (including ground).

33. The process chamber (2) according to any one of claims 1 to 32, further comprising a sputtering target.

34. A plasma processing apparatus comprising:
a process chamber according to any one of the preceding claims,
an electromagnetic energy inductor (4) external of said process chamber for delivering electromagnetic energy thereto, and
an energy source (6) for driving said inductor.

35. The plasma processing apparatus according to claim 34, further comprising biasing means for biasing the conductive means (16) of the process chamber (2) with an ac voltage (including an RF voltage) or a dc voltage (including ground).

36. The plasma processing apparatus according to claim 35, wherein said biasing means comprises means for independently biasing two or more isolated sections of the conductive means (16) of the process chamber (2).

37. Use of a plasma processing apparatus according to any one of claims 34 to 36 for depositing a conductive film on a workpiece.

38. Use of a plasma processing apparatus according to any one of claims 34 to 36 for ion etching on a workpiece.

## Claims (Claims for the following Contracting State(s): CH, DE, FR, GB, IT, LI, NL)

1. A process chamber (2) for a plasma processing apparatus, said chamber being bounded by wall portions and adapted to receive electromagnetic energy by inductive coupling from an external inductor (4) connected to an ac supply (6), to create, enhance or sustain a plasma therein,
said chamber comprising conductive means (16) arranged within said chamber (2) to confront at least a part of the internal surface of the wall portions such as to inhibit coating thereon of material evolved from plasma processing,
**characterised in that** said conductive means comprises at least one conductive element (52) in physical contact with said internal surface.

2. The process chamber according to claim 1, wherein said at least one conductive element (52) is pressed against said internal surface through resilient mount means (68).

3. The process chamber (2) according to claim 1 or 2, wherein said at least one conductive element (52) consists of a series of conductive elements (52) dependent from a mechanical support means (50) and distributed so as to form an array that is in physical contact with said internal surface.

4. The process chamber (2) according to claim 3, wherein said conductive elements are in the form of elongate rectangular panels (52) whose major length extends parallel to a principal axis of the process chamber (2).

5. The process chamber (2) according to any one of claims 1 to 4, wherein said conductive means (16) comprises at least one aperture (18; 56; 62) for allowing the passage of electromagnetic energy into said process chamber.

6. The process chamber (2) according to claim 5, wherein said apertures(s) (18; 56; 62) are arranged so as to break down circulating currents induced in said conductive means (16) into plural current loops.

7. The process chamber (2) according to claim 5 or 6, wherein said apertures form a series of slits (18).

8. The process chamber (2) according to any one of claims 5 to 7, wherein said apertures (62) define an indirect path for the electromagnetic energy from the inductor to inside the chamber.

9. The process chamber (2) according to any one of claims 5 to 8, wherein said apertures (18; 56; 62) are distributed uniformly over said conductive means (16).

10. The process chamber (2) according to any one of claims 5 to 9 when dependent on claim 3 or 4, wherein said apertures are defined by spaces (56; 62) separating neighbouring conductive elements (52).

11. The process chamber (2) according to claim 10 when dependent on claim 8, wherein said conductive elements (52a) are profiled so as to overlap in a non-contacting manner with neighbouring conductive elements in order to define said indirect path (figure 10).

12. The process chamber (2) according to claim 10 when dependent on claim 8, wherein said conductive elements (52) are imbricated in a non-contacting manner with their neighbouring conductive elements at confronting edges to define said indirect path (figures 8, 9).

13. The process chamber (2) according to any one of claims 1 to 12, wherein said conductive structure (16) bounds a space inside said chamber within which a plasma condition is to be created.

14. The process chamber (2) according to claim 13, wherein said space includes a space within which a workpiece (16) is to be received.

15. The process chamber (2) according to claim 13, wherein said space is outside a space within which a workpiece (16) is to be received.

16. The process chamber (2) according to claim 15 comprising an inlet (8) for reaction material e.g. a gas or gas mixture outside said space bound by said conductive means (16).

17. The process chamber (2) according to any one of claims 1 to 16, containing an ion source (16; 100, 104; 110) therewithin.

18. The process chamber (2) according to claim 17, wherein said conductive means (16) constitutes said ion source.

19. The process chamber (2) according to claim 18, wherein said conductive means (16) is connectable to an electrical energy source (7) to form an ion sputtering source.

20. The process chamber (2) according to claim 17 or 18, wherein said conductive means (16) is made at least in part of a material comprising the material to be coated.

21. The process chamber (2) according to claim 17, wherein said ion source comprises a cathode (100) associated with a magnetron (104).

22. The process chamber (2) according to claim 21, wherein said cathode (100) is provided at an end of portion of a space bound by said conductive means (16).

23. The process chamber (2) according to claim 17, wherein said ion source comprises a source (114) of metallic vapour and activating means (112) for transmitting energy to vaporise said source.

24. The process chamber (2) according to claim 23, wherein said activating means (112) comprises a particle beam generator, e.g. an electron beam generator.

25. The process chamber (2) according to any one of claims 1 to 24, wherein said conductive means (16) is cooled by a fluid flow.

26. The process chamber (2) according to any one of claims 1 to 25, further comprising biasing means for electrically biasing said conductive means (16) with an ac voltage (including an RF voltage) or a dc voltage (including ground).

27. The process chamber (2) according to claim 26, wherein said conductive means (16) is divided into two or more isolated sections, said biasing means being operative for biasing said sections separately.

28. The process chamber (2) according to any one of claims 1 to 27, wherein said conductive means (16) further comprises at least one window portion (38) to enhance plasma ignition.

29. The process chamber (2) according to claim 28, further comprising shutter means (40) for adjusting the degree of opening of said window (38).

30. The process chamber (2) according to any one of claims 1 to 29, further comprising a workpiece-supporting stage which is connectable to a biasing source to bias a workpiece on said stage, either directly or via a temperature-controlled susceptor, with an ac voltage (including an RF voltage) or a dc voltage (including ground).

31. The process chamber (2) according to any one of claims 1 to 30, further comprising a sputtering target.

32. A plasma processing apparatus comprising:
a process chamber according to any one of the preceding claims,
an electromagnetic energy inductor (4) external of said process chamber for delivering electromagnetic energy thereto, and
an energy source (6) for driving said inductor.

33. The plasma processing apparatus according to claim 32, further comprising biasing means for biasing the conductive means (16) of the process chamber (2) with an ac voltage (including an RF voltage) or a dc voltage (including ground).

34. The plasma processing apparatus according to claim 33, wherein said biasing means comprises means for independently biasing two or more isolated sections of the conductive means (16) of the process chamber (2).

35. Use of a plasma processing apparatus according to any one of claims 32 to 34 for depositing a conductive film on a workpiece.

36. Use of a plasma processing apparatus according to any one of claims 32 to 34 for ion etching on a workpiece.

## Patentansprüche (Patentansprüche für folgende(n) Vertragsstaat(en): AT, BE, DK, ES, FI, GR, IE, LU, PT und SE)

1. Vorrichtung, die eine Bearbeitungskammer (2) zur Plasma Behandlung benutzt, wobei diese Kammer durch Wandabschnitte begrenzt und ausgelegt ist, um elektromagnetische Energie durch induktive Kopplung von einem externen Induktor (4), der an eine AC-Quelle (6) angeschlossen ist, zu empfangen, um in ihr ein Plasma herzustellen, zu verstärken oder aufrecht zu erhalten,
wobei diese Kammer leitende Mittel (16) umfasst, die innerhalb dieser Kammer (2) so angeordnet sind, dass sie mindestens einem Teil der inneren Oberfläche der Wandabschnitte gegenüber stehen, um zu verhindern, dass sich Material, das bei der Plasma Behandlung freigesetzt wird, darauf niederschlägt,
**dadurch gekennzeichnet, dass** dieses leitende Mittel in einer Entfernung von weniger als 10 mm von dieser inneren Oberfläche angeordnet ist.

2. Bearbeitungskammer nach Anspruch 1, wobei diese Entfernung weniger als 1 mm beträgt.

3. Bearbeitungskammer nach Anspruch 2, wobei dieses leitende Mittel (16) mindestens ein leitendes Element (52) in physischem Kontakt mit dieser Innenoberfläche umfasst.

4. Bearbeitungskammer nach Anspruch 3, wobei dieses mindestens eine Leitelement (52) durch federnde Befestigungsmittel (68) gegen diese Innenoberfläche gepresst wird.

5. Bearbeitungskammer (2) nach Anspruch 3 oder 4, wobei dieses mindestens eine Leitelement (52) aus einer Reihe von Leitelementen (52) besteht, die von einem mechanischen Träger (50) abhängen und so verteilt sind, dass sie eine regelmäßige Anordnung bilden, die in physischem Kontakt mit der Innenoberfläche steht.

6. Bearbeitungskammer (2) nach Anspruch 5, wobei diese Leitelemente die Form verlängerter, rechtwinkliger Platten (52) haben, deren größere Länge parallel zur Hauptachse der Bearbeitungskammer (2) verläuft.

7. Bearbeitungskammer (2) nach irgendeinem der Ansprüche 1 bis 6, wobei dieses Leitmittel (16) mindestens eine Öffnung (18, 56, 62) umfasst, die den Durchgang elektromagnetischer Energie in die Bearbeitungskammer ermöglicht.

8. Bearbeitungskammer (2) nach Anspruch 7, wobei diese Öffnung(en) (18, 56, 62) so angeordnet ist (sind), dass sie zirkulierende Ströme, die in dieses Leitmittel (16) induziert werden, in mehrere Stromschleifen unterbricht (unterbrechen).

9. Bearbeitungskammer (2) nach Anspruch 7 oder 8, wobei diese Öffnungen eine Reihe von Schlitzen (18) bilden.

10. Bearbeitungskammer (2) nach irgendeinem der Ansprüche 7 bis 9, wobei diese Öffnungen (62) für die elektromagnetische Energie vom Induktor ins Innere der Kammer einen indirekten Pfad definieren.

11. Bearbeitungskammer (2) nach irgendeinem der Ansprüche 7 bis 10, wobei diese Öffnungen (18, 56, 62) einheitlich über dieses Leitmittel (16) verteilt sind.

12. Bearbeitungskammer (2) nach irgendeinem der Ansprüche 7 bis 11, sofern abhängig von Anspruch 5 oder 6, wobei diese Öffnungen durch Räume (56, 62) definiert sind, die benachbarte Leitelemente (52) voneinander trennen.

13. Bearbeitungskammer (2) nach Anspruch 12, sofern abhängig von Anspruch 10, wobei diese Leitelemente (52a) so profiliert sind, dass sie ohne sich zu berühren mit benachbarten Leitelementen überlappen, um diesen indirekten Pfad (Abbildung 10) zu definieren.

14. Bearbeitungskammer (2) nach Anspruch 12, sofern abhängig von Anspruch 10, wobei diese Leitelemente (52) ohne sich zu berühren mit ihren benachbarten Leitelementen an gegenüber stehenden Kanten dachziegelartig übereinander liegen, um diesen indirekten Pfad (Abbildungen 8, 9) zu definieren.

15. Bearbeitungskammer (2) nach irgendeinem der Ansprüche 1 bis 14, wobei diese Leitstruktur (16) einen Raum innerhalb der Kammer begrenzt, innerhalb dessen eine Plasmabedingung hergestellt werden soll.

16. Bearbeitungskammer (2) nach Anspruch 15, wobei der genannte Raum einen Raum einschließt, innerhalb dessen ein Werkstück (16) aufgenommen werden soll.

17. Bearbeitungskammer (2) nach Anspruch 15, wobei der genannte Raum außerhalb eines Raumes ist, innerhalb dessen ein Werkstück (16) aufgenommen werden soll.

18. Bearbeitungskammer (2) nach Anspruch 17, die einen Einlass (8) für Reaktionsmaterial, z. B. ein Gas oder Gasgemisch, außerhalb des genannten Raums umfasst, der durch die Leitstruktur (16) begrenzt ist.

19. Bearbeitungskammer (2) nach irgendeinem der Ansprüche 1 bis 18, die eine lonenquelle (16, 100, 104, 110) beinhaltet.

20. Bearbeitungskammer (2) nach Anspruch 19, wobei das Leitmittel (16) die genannte lonenquelle darstellt.

21. Bearbeitungskammer (2) nach Anspruch 20, wobei das Leitmittel (16) an eine elektrische Energiequelle (7) angeschlossen werden kann, um eine lonenzerstäuberquelle zu bilden.

22. Bearbeitungskammer (2) nach Anspruch 19 oder 20, wobei das Leitmittel (16) zumindest zum Teil aus einem Material besteht, welches das aufzutragende Material umfasst.

23. Bearbeitungskammer (2) nach Anspruch 19, wobei die lonenquelle eine Kathode (100) assoziiert mit einem Magnetron (104) umfasst.

24. Bearbeitungskammer (2) nach Anspruch 23, wobei diese Kathode (100) an einem Abschnittsende eines Raumes vorgesehen ist, der durch das Leitmittel (16) begrenzt ist.

25. Bearbeitungskammer (2) nach Anspruch 19, wobei die genannte lonenquelle eine Quelle (114) metallischen Dampfes und eines aktivierenden Mittels (112) für die Übertragung von Energie umfasst, um die genannte Quelle zu verdampfen.

26. Bearbeitungskammer (2) nach Anspruch 25, wobei das aktivierende Mittel (112) einen Partikel ausstrahlenden Generator, z. B. einen Elektronen ausstrahlenden Generator umfasst.

27. Bearbeitungskammer (2) nach irgendeinem der Ansprüche 1 bis 26, wobei das Leitmittel (16) durch einen Fluidfluss gekühlt wird.

28. Bearbeitungskammer (2) nach irgendeinem der Ansprüche 1 bis 27, die weiter ein Vorspannungsmittel zum elektrischen Vorspannen des Leitmittels (16) mit einer AC-Spannung (einschließlich RF-Spannung) oder einer Gleichstromspannung einschließlich Erde) umfasst.

29. Bearbeitungskammer (2) nach Anspruch 28, wobei das Leitmittel (16) in zwei oder mehrere isolierte Abschnitte geteilt ist und das Vorspannungsmittel diese Sektionen getrennt vorspannen kann.

30. Bearbeitungskammer (2) nach irgendeinem der Ansprüche 1 bis 29, wobei das Leitmittel (16) weiter mindestens einen Fensterabschnitt (38) umfasst, um die Plasma Zündung zu verstärken.

31. Bearbeitungskammer (2) nach Anspruch 30, die weiter eine Verschlussvorrichtung (40) zum Regeln des Öffnungsgrades dieses Fensters (38) umfasst.

32. Bearbeitungskammer (2) nach irgendeinem der Ansprüche 1 bis 31, die weiter ein Werkstück tragendes Gerüst umfasst, das an eine Vorspannungsquelle angeschlossen werden kann, um ein Werkstück auf diesem Gerüst entweder direkt oder über einen temperaturgeregelten Träger mit einer AC Spannung (einschließlich RF-Spannung) oder einer Gleichstromspannung (einschließlich Erde) vorzuspannen.

33. Bearbeitungskammer (2) nach irgendeinem der Ansprüche 1 bis 32, die weiter ein Zerstäuberziel umfasst.

34. Vorrichtung zur Plasma Behandlung, welche umfasst:
eine Bearbeitungskammer nach irgendeinem der vorstehenden Ansprüche,
einen Induktor (4) für elektromagnetische Energie, der außerhalb der Bearbeitungskammer angeordnet ist, zu deren Belieferung mit elektromagnetischer Energie und
eine Energiequelle (6) zum Antrieb dieses Induktors.

35. Vorrichtung zur Plasma Behandlung nach Anspruch 34, die weiter Vorspannungsmittel zur Vorspannung des Leitmittels (16) der Bearbeitungskammer (2) mit einer AC Spannung (einschließlich RF-Spannung) oder einer Gleichstromspannung (einschließlich Erde) umfasst.

36. Vorrichtung zur Plasma Behandlung nach Anspruch 35, wobei dieses Vorspannungsmittel Mittel umfasst zum unabhängigen Vorspannen zweier oder mehrerer isolierter Abschnitte des Leitmittels (16) der Bearbeitungskammer (2).

37. Benutzung der Vorrichtung zur Plasma Behandlung nach irgendeinem der Ansprüche 34 bis 36 zum Auftragen eines leitenden Films auf ein Werkstück.

38. Benutzung der Vorrichtung zur Plasma Behandlung nach irgendeinem der Ansprüche 34 bis 36 zum lonenätzen auf einem Werkstück.

## Patentansprüche (Patentansprüche für folgende(n) Vertragsstaat(en): CH, DE, FR, GB, IT, LI und NL)

1. Vorrichtung, die eine Bearbeitungskammer (2) zur Plasma Behandlung benutzt, wobei diese Kammer durch Wandabschnitte begrenzt und ausgelegt ist, um elektromagnetische Energie durch induktive Kopplung von einem externen Induktor (4), der an eine AC-Quelle (6) angeschlossen ist, aufzunehmen, um in ihr ein Plasma herzustellen, zu verstärken oder aufrecht zu erhalten,
wobei diese Kammer ein leitendes Mittel (16) umfasst, das innerhalb dieser Kammer (2) so angeordnet ist, dass es mindestens einem Teil der inneren Oberfläche der Wandabschnitte gegenüber steht, um zu verhindern, dass sich Material, das bei der Plasma Behandlung freigesetzt wird, darauf niederschlägt,
**dadurch gekennzeichnet, dass** dieses leitende Mittel mindestens ein Leitelement (52) umfasst, das in physischem Kontakt mit der genannten Innenoberfläche ist.

2. Bearbeitungskammer nach Anspruch 1, wobei dieses mindestens eine Leitelement (52) durch federnde Befestigungsmittel (68) gegen diese Innenoberfläche gepresst wird.

3. Bearbeitungskammer (2) nach Anspruch 1 oder 2, wobei dieses mindestens eine Leitelement (52) aus einer Reihe von Leitelementen (52) besteht, die von einem mechanischen Träger (50) abhängen und so verteilt sind, dass sie eine regelmäßige Anordnung bilden, die in physischem Kontakt mit der Innenoberfläche steht.

4. Bearbeitungskammer (2) nach Anspruch 3, wobei diese Leitelemente die Form verlängerter, rechtwinkliger Platten (52) haben, deren größere Länge parallel zur Hauptachse der Bearbeitungskammer (2) verläuft.

5. Bearbeitungskammer (2) nach irgendeinem der Ansprüche 1 bis 4, wobei dieses Leitmittel (16) mindestens eine Öffnung (18, 56, 62) umfasst, die den Durchgang elektromagnetischer Energie in die Bearbeitungskammer ermöglicht.

6. Bearbeitungskammer (2) nach Anspruch 5, wobei diese Öffnung(en) (18, 56, 62) so angeordnet ist (sind), dass sie zirkulierende Ströme, die in dieses Leitmittel (16) induziert werden, in mehrere Stromschleifen unterbricht (unterbrechen).

7. Bearbeitungskammer (2) nach Anspruch 5 oder 6, wobei diese Öffnungen eine Reihe von Schlitzen (18) bilden.

8. Bearbeitungskammer (2) nach irgendeinem der Ansprüche 5 bis 7, wobei diese Öffnungen (62) für die elektromagnetische Energie vom Induktor ins Innere der Kammer einen indirekten Pfad definieren.

9. Bearbeitungskammer (2) nach irgendeinem der Ansprüche 5 bis 8, wobei diese Öffnungen (18, 56, 62) einheitlich über dieses Leitmittel (16) verteilt sind.

10. Bearbeitungskammer (2) nach irgendeinem der Ansprüche 5 bis 9, sofern abhängig von Anspruch 3 oder 4, wobei diese Öffnungen durch Räume (56, 62) definiert sind, die benachbarte Leitelemente (52) voneinander trennen.

11. Bearbeitungskammer (2) nach Anspruch 10, sofern abhängig von Anspruch 8, wobei diese Leitelemente (52a) so profiliert sind, dass sie ohne sich zu berühren mit benachbarten Leitelementen überlappen, um diesen indirekten Pfad (Abbildung 10) zu definieren.

12. Bearbeitungskammer (2) nach Anspruch 10, sofern abhängig von Anspruch 8, wobei diese Leitelemente (52) ohne sich zu berühren mit ihren benachbarten Leitelementen an gegenüber stehenden Ecken dachziegelartig übereinander liegen, um diesen indirekten Pfad (Abbildung 8, 9) zu definieren.

13. Bearbeitungskammer (2) nach irgendeinem der Ansprüche 1 bis 12, wobei diese Leitstruktur (16) einen Raum innerhalb der Kammer begrenzt, innerhalb dessen eine Plasmabedingung hergestellt werden soll.

14. Bearbeitungskammer (2) nach Anspruch 13, wobei der genannte Raum einen Raum einschließt, innerhalb dessen ein Werkstück (16) aufgenommen werden soll.

15. Bearbeitungskammer (2) nach Anspruch 13, wobei der genannte Raum außerhalb eines Raumes ist, innerhalb dessen ein Werkstück (16) aufgenommen werden soll.

16. Bearbeitungskammer (2) nach Anspruch 15, die einen Einlass (8) für Reaktionsmaterial, z. B. ein Gas oder Gasgemisch, außerhalb des genannten Raums umfasst, der durch die Leitstruktur (16) begrenzt ist.

17. Bearbeitungskammer (2) nach irgendeinem der Ansprüche 1 bis 16, die eine lonenquelle (16, 100, 104, 110) beinhaltet.

18. Bearbeitungskammer (2) nach Anspruch 17, wobei das Leitmittel (16) die genannte lonenquelle darstellt.

19. Bearbeitungskammer (2) nach Anspruch 18, wobei das Leitmittel (16) an eine elektrische Energiequelle (7) angeschlossen werden kann, um eine lonenzerstäuberquelle zu bilden.

20. Bearbeitungskammer (2) nach Anspruch 17 oder 18, wobei das Leitmittel (16) zumindest zum Teil aus einem Material besteht, welches das aufzutragende Material umfasst.

21. Bearbeitungskammer (2) nach Anspruch 17, wobei die lonenquelle eine Kathode (100) assoziiert mit einem Magnetron (104) umfasst.

22. Bearbeitungskammer (2) nach Anspruch 21, wobei diese Kathode (100) an einem Abschnittsende eines Raumes vorgesehen ist, der durch das Leitmittel (16) begrenzt ist.

23. Bearbeitungskammer (2) nach Anspruch 17, wobei die genannte lonenquelle eine Quelle (114) metallischen Dampfes und eines aktivierenden Mittels (112) für die Übertragung von Energie umfasst, um die genannte Quelle zu verdampfen.

24. Bearbeitungskammer (2) nach Anspruch 23, wobei das aktivierende Mittel (112) einen Partikel ausstrahlenden Generator, z. B. einen Elektronen ausstrahlenden Generator umfasst.

25. Bearbeitungskammer (2) nach irgendeinem der Ansprüche 1 bis 24, wobei das Leitmittel (16) durch einen Fluidfluss gekühlt wird.

26. Bearbeitungskammer (2) nach irgendeinem der Ansprüche 1 bis 25, die weiter ein Vorspannungsmittel zum elektrischen Vorspannen des Leitmittels (16) mit einer AC-Spannung (einschließlich RF Spannung) oder einer Gleichstromspannung (einschließlich Erde) umfasst.

27. Bearbeitungskammer (2) nach Anspruch 26, wobei das Leitmittel (16) in zwei oder mehrere isolierte Abschnitte geteilt ist und das Vorspannungsmittel diese Sektionen getrennt vorspannen kann.

28. Bearbeitungskammer (2) nach irgendeinem der Ansprüche 1 bis 27, wobei das Leitmittel (16) weiter mindestens einen Fensterabschnitt (38) umfasst, um die Plasmazündung zu verstärken.

29. Bearbeitungskammer (2) nach Anspruch 28, die weiter eine Verschlussvorrichtung (40) zum Regeln des Öffnungsgrades dieses Fensters (38) umfasst.

30. Bearbeitungskammer (2) nach irgendeinem der Ansprüche 1 bis 29, die weiter ein Werkstück tragendes Gerüst umfasst, das an eine Vorspannungsquelle angeschlossen werden kann, um ein Werkstück auf diesem Gerüst entweder direkt oder über einen temperaturgeregelten Träger mit einer AC-Spannung (einschließlich RF Spannung) oder einer Gleichstromspannung (einschließlich Erde) vorzuspannen.

31. Bearbeitungskammer (2) nach irgendeinem der Ansprüche 1 bis 30, die weiter ein Zerstäuberziel umfasst.

32. Vorrichtung zur Plasma Behandlung, welche umfasst:
eine Bearbeitungskammer nach irgendeinem der vorstehenden Ansprüche,
einen Induktor (4) für elektromagnetische Energie, der außerhalb der Bearbeitungskammer angeordnet ist, zu deren Belieferung mit elektromagnetischer Energie und
eine Energiequelle (6) zum Antrieb dieses Induktors.

33. Vorrichtung zur Plasma Behandlung nach Anspruch 32, die weiter Vorspannungsmittel zur Vorspannung des Leitmittels (16) der Bearbeitungskammer (2) mit einer AC-Spannung (einschließlich RF Spannung) oder einer Gleichstromspannung (einschließlich Erde) umfasst.

34. Vorrichtung zur Plasma Behandlung nach Anspruch 33, wobei dieses Vorspannungsmittel Mittel umfasst zum unabhängigen Vorspannen zweier oder mehrerer isolierter Abschnitte des Leitmittels (16) der Bearbeitungskammer (2).

35. Benutzung der Vorrichtung zur Plasma Behandlung nach irgendeinem der Ansprüche 32 bis 34 zum Auftragen eines leitenden Films auf ein Werkstück.

36. Benutzung der Vorrichtung zur Plasma Behandlung nach irgendeinem der Ansprüche 32 bis 34 zum lonenätzen auf einem Werkstück.

## Revendications (Revendications pour l'(les) Etat(s) contractant(s) suivant(s): AT, BE, DK, ES, FI, GR, IE, LU, PT et SE)

1. Chambre de traitement (2) pour un appareil de traitement par plasma, ladite chambre étant limitée par des parties de paroi et adaptée pour recevoir de l'énergie électromagnétique par couplage inductif à partir d'une inductance externe (4) connectée à une alimentation à courant alternatif (6), pour créer, accroître ou entretenir un plasma à l'intérieur,
ladite chambre comprenant un moyen conducteur (16) disposé à l'intérieur de ladite chambre (2) pour être opposé à au moins une partie de la surface intérieure des parties de paroi de manière à empêcher une application dessus de matière émise par traitement par plasma,
**caractérisée en ce que** ledit moyen conducteur est disposé à une distance inférieure à 10 mm de la surface intérieure.

2. Chambre de traitement selon la revendication 1, dans laquelle ladite distance est inférieure à 1 mm.

3. Chambre de traitement selon la revendication 2, dans laquelle ledit moyen conducteur (16) comprend au moins un élément conducteur (52) en contact physique avec ladite surface interne.

4. Chambre de traitement selon la revendication 3, dans laquelle au moins un élément conducteur (52) est appuyé contre ladite surface intérieure à l'aide de moyens de supports élastiques (68).

5. Chambre de traitement (2) selon la revendication 3 ou 4, dans laquelle au moins un élément conducteur (52) est constitué d'une série d'éléments conducteurs (52) suspendus à un moyen de support mécanique (50) et répartis de manière à former un réseau qui est en contact physique avec ladite surface intérieure.

6. Chambre de traitement (2) selon la revendication 5, dans laquelle lesdits éléments conducteurs ont la forme de panneaux rectangulaires allongés (52) dont la plus grande longueur s'étend parallèlement à un axe principal de la chambre de traitement (2).

7. Chambre de traitement (2) selon l'une quelconque des revendications 1 à 6, dans laquelle ledit moyen conducteur (16) comprend au moins une ouverture (18 ; 56 ; 62) pour permettre le passage d'énergie électromagnétique dans ladite chambre de traitement.

8. Chambre de traitement (2) selon la revendication 7, dans laquelle ladite ou lesdites ouvertures (18 ; 56 ; 62) sont disposées de manière à partager les courants induits circulant dans ledit moyen conducteur (16) en plusieurs boucles de courant.

9. Chambre de traitement (2) selon la revendication 7 ou 8, dans laquelle lesdites ouvertures forment une série de fentes (18).

10. Chambre de traitement (2) selon l'une quelconque des revendications 7 à 9, dans laquelle lesdites ouvertures (62) définissent un trajet indirect pour l'énergie électromagnétique de l'inducteur jusqu'à l'intérieur de la chambre.

11. Chambre de traitement (2) selon l'une quelconque des revendications 7 à 10, dans laquelle lesdites ouvertures (18 ; 56 ; 62) sont réparties uniformément sur ledit moyen conducteur (16).

12. Chambre de traitement (2) selon l'une quelconque des revendications 7 à 11, lorsque liées à la revendication 5 ou 6, dans laquelle lesdites ouvertures sont définies par des espaces (56 ; 62) séparant des éléments conducteurs voisins (52).

13. Chambre de traitement (2) selon la revendication 12, lorsque liées à la revendication 10, dans laquelle lesdits éléments conducteurs (52a) sont profilés afin de chevaucher d'une manière sans contact les éléments conducteurs voisins de manière à définir ledit trajet indirect (figure 10).

14. Chambre de traitement (2) selon la revendication 12, lorsque liées à la revendication 10, dans laquelle lesdits éléments conducteurs (52) sont imbriqués d'une manière sans contact avec leurs éléments conducteurs voisins à des bords opposés pour définir ledit trajet indirect (figures 8, 9).

15. Chambre de traitement (2) selon l'une quelconque des revendications 1 à 14, dans laquelle ladite structure conductrice (16) délimite un espace dans ladite chambre à l'intérieur de laquelle une condition de plasma est à créer.

16. Chambre de traitement (2) selon la revendication 15, dans laquelle ledit espace comprend un espace à l'intérieur duquel une pièce (16) est à recevoir.

17. Chambre de traitement (2) selon la revendication 15, dans laquelle ledit espace est en dehors d'un espace à l'intérieur duquel une pièce (16) est à recevoir.

18. Chambre de traitement (2) selon la revendication 17, comprenant une entrée (8) pour la matière de réaction, par exemple un gaz ou un mélange de gaz à l'extérieur dudit espace délimité par ledit moyen conducteur (16).

19. Chambre de traitement (2) selon l'une quelconque des revendications 1 à 18, contenant une source d'ions (16; 100, 104 ; 110) à l'intérieur.

20. Chambre de traitement (2) selon la revendication 19, dans laquelle ledit moyen conducteur (16) constitue ladite source d'ions.

21. Chambre de traitement (2) selon la revendication 20, dans laquelle ledit moyen conducteur (16) peut être connecté à une source d'énergie électrique (7) pour former une source de pulvérisation d'ions.

22. Chambre de traitement (2) selon la revendication 19 ou 20, dans laquelle ledit moyen conducteur (16) est fabriqué au moins en partie en un matériau comprenant la matière à appliquer.

23. Chambre de traitement (2) selon la revendication 19, dans laquelle ladite source d'ions comprend une cathode (100) associée à un magnétron (104).

24. Chambre de traitement (2) selon la revendication 23, dans laquelle ladite cathode (100) est équipée à une extrémité de partie d'un espace limité par ledit moyen conducteur (16).

25. Chambre de traitement (2) selon la revendication 19, dans laquelle ladite source d'ions comprend une source (114) de vapeur métallique et d'un moyen d'activation (112) pour transmettre de l'énergie pour vaporiser ladite source.

26. Chambre de traitement (2) selon la revendication 25, dans laquelle ledit moyen d'activation (112) comprend un générateur de faisceaux de particules, par exemple un générateur de faisceaux d'électrons.

27. Chambre de traitement (2) selon l'une quelconque des revendications 1 à 26, dans laquelle ledit moyen conducteur (16) est refroidi par un écoulement fluide.

28. Chambre de traitement (2) selon l'une quelconque des revendications 1 à 27, comprenant en outre un moyen de polarisation pour polariser électriquement ledit moyen conducteur (16) avec une tension alternative (comprenant une tension RF) ou une tension continue (comprenant la masse)/

29. Chambre de traitement (2) selon la revendication 28, dans laquelle ledit moyen conducteur (16) est divisé en deux ou plusieurs sections isolées, ledit moyen de polarisation étant actif pour polariser lesdites sections séparément.

30. Chambre de traitement (2) selon l'une quelconque des revendications 1 à 29, dans laquelle ledit moyen conducteur (16) comprend en outre au moins une partie à fenêtre (38) pour améliorer l'allumage du plasma.

31. Chambre de traitement (2) selon la revendication 30, comprenant en outre des moyens à volets (40) pour ajuster le degré d'ouverture de ladite fenêtre (38).

32. Chambre de traitement (2) selon l'une quelconque des revendications 1 à 31, comprenant en outre un plateau support de pièce qui peut être connecté à une source de polarisation pour polariser une pièce sur ledit plateau, soit directement soit par l'intermédiaire d'un support à température régulée, avec une tension alternative (comprenant une tension RF) ou une tension continue (comprenant la masse).

33. Chambre de traitement (2) selon l'une quelconque des revendications 1 à 32, comprenant en outre une cible de pulvérisation.

34. Appareil de traitement par plasma, comprenant :
une chambre de traitement selon l'une quelconque des revendications précédentes,
un inducteur d'énergie électromagnétique (4) à l'extérieur de ladite chambre de traitement pour y délivrer de l'énergie électromagnétique, et
une source d'énergie (6) pour entraîner ledit inducteur.

35. Appareil de traitement par plasma, selon la revendication 34, comprenant en outre un moyen de polarisation pour polariser le moyen conducteur (16) de la chambre de traitement (2) avec une tension alternative (comprenant une tension RF) ou une tension continue (comprenant la masse).

36. Appareil de traitement par plasma, selon la revendication 35, dans lequel ledit moyen de polarisation comprend un moyen pour polariser indépendamment deux sections isolées ou plus du moyen conducteur (16) de la chambre de traitement (2).

37. Utilisation d'un appareil de traitement par plasma selon l'une quelconque des revendications 34 à 36 pour déposer un film conducteur sur une pièce.

38. Utilisation d'un appareil de traitement par plasma selon l'une quelconque des revendications 34 à 36 pour la gravure ionique sur une pièce.

## Revendications (Revendications pour l'(les) Etat(s) contractant(s) suivant(s): CH, DE, FR, GB, IT, LI, NL)

1. Chambre de traitement (2) pour un appareil de traitement par plasma, ladite chambre étant limitée par des parties de paroi et adaptée pour recevoir de l'énergie électromagnétique par couplage inductif à partir d'une inductance externe (4) connectée à une alimentation à courant alternatif (6), pour créer, accroître ou entretenir un plasma à l'intérieur,
ladite chambre comprenant un moyen conducteur (16) disposé à l'intérieur de ladite chambre (2) pour être opposé à au moins une partie de la surface intérieure des parties de paroi de manière à empêcher une application dessus de matière émise par traitement par plasma,
**caractérisée en ce que** ledit moyen conducteur (16) comprend au moins un élément conducteur (52) en contact physique avec ladite surface intérieure.

2. Chambre de traitement selon la revendication 1, dans laquelle au moins un élément conducteur (52) est appuyé contre ladite surface intérieure à l'aide de moyens de supports élastiques (68).

3. Chambre de traitement (2) selon la revendication 1 ou 2, dans laquelle au moins un élément conducteur (52) est constitué d'une série d'éléments conducteurs (52) suspendus à un moyen de support mécanique (50) et répartis de manière à former un réseau qui est en contact physique avec ladite surface intérieure.

4. Chambre de traitement (2) selon la revendication 3, dans laquelle lesdits éléments conducteurs ont la forme de panneaux rectangulaires allongés (52) dont la plus grande longueur s'étend parallèlement à un axe principal de la chambre de traitement (2).

5. Chambre de traitement (2) selon l'une quelconque des revendications 1 à 4, dans laquelle ledit moyen conducteur (16) comprend au moins une ouverture (18 ; 56 ; 62) pour permettre le passage d'énergie électromagnétique dans ladite chambre de traitement.

6. Chambre de traitement (2) selon la revendication 5, dans laquelle ladite ou lesdites ouvertures (18 ; 56 ; 62) sont disposées de manière à partager les courants induits circulant dans ledit moyen conducteur (16) en plusieurs boucles de courant.

7. Chambre de traitement (2) selon la revendication 5, ou 6, dans laquelle lesdites ouvertures forment une série de fentes (18).

8. Chambre de traitement (2) selon l'une quelconque des revendications 5 à 7, dans laquelle lesdites ouvertures (62) définissent un trajet indirect pour l'énergie électromagnétique de l'inducteur jusqu'à l'intérieur de la chambre.

9. Chambre de traitement (2) selon l'une quelconque des revendications 5 à 8, dans laquelle lesdites ouvertures (18 ; 56 ; 62) sont réparties uniformément sur ledit moyen conducteur (16).

10. Chambre de traitement (2) selon l'une quelconque des revendications 5 à 9, lorsque liées à la revendication 3 ou 4, dans laquelle lesdites ouvertures sont définies par des espaces (56 ; 62) séparant des éléments conducteurs voisins (52).

11. Chambre de traitement (2) selon la revendication 10, lorsque liées à la revendication 8, dans laquelle lesdits éléments conducteurs (52a) sont profilés afin de chevaucher d'une manière sans contact les éléments conducteurs voisins de manière à définir ledit trajet indirect (figure 10).

12. Chambre de traitement (2) selon la revendication 10, lorsque liées à la revendication 8, dans laquelle lesdits éléments conducteurs (52) sont imbriqués d'une manière sans contact avec leurs éléments conducteurs voisins à des bords opposés pour définir ledit trajet indirect (figures 8, 9).

13. Chambre de traitement (2) selon l'une quelconque des revendications 1 à 12, dans laquelle ladite structure conductrice (16) délimite un espace dans ladite chambre à l'intérieur de laquelle une condition de plasma est à créer.

14. Chambre de traitement (2) selon la revendication 13, dans laquelle ledit espace comprend un espace à l'intérieur duquel une pièce (16) est à recevoir.

15. Chambre de traitement (2) selon la revendication 13, dans laquelle ledit espace est en dehors d'un espace à l'intérieur duquel une pièce (16) est à recevoir.

16. Chambre de traitement (2) selon la revendication 15, comprenant une entrée (8) pour la matière de réaction, par exemple un gaz ou un mélange de gaz à l'extérieur dudit espace délimité par ledit moyen conducteur (16).

17. Chambre de traitement (2) selon l'une quelconque des revendications 1 à 16, contenant une source d'ions (16 ; 100, 104 ; 110) à l'intérieur.

18. Chambre de traitement (2) selon la revendication 17, dans laquelle ledit moyen conducteur (16) constitue ladite source d'ions.

19. Chambre de traitement (2) selon la revendication 18, dans laquelle ledit moyen conducteur (16) peut être connecté à une source d'énergie électrique (7) pour former une source de pulvérisation d'ions.

20. Chambre de traitement (2) selon la revendication 17 ou 18, dans laquelle ledit moyen conducteur (16) est fabriqué au moins en partie en un matériau comprenant la matière à appliquer.

21. Chambre de traitement (2) selon la revendication 17, dans laquelle ladite source d'ions comprend une cathode (100) associée à un magnétron (104).

22. Chambre de traitement (2) selon la revendication 21, dans laquelle ladite cathode (100) est équipée à une extrémité de partie d'un espace limité par ledit moyen conducteur (16).

23. Chambre de traitement (2) selon la revendication 17, dans laquelle ladite source d'ions comprend une source (114) de vapeur métallique et d'un moyen d'activation (112) pour transmettre de l'énergie pour vaporiser ladite source.

24. Chambre de traitement (2) selon la revendication 23, dans laquelle ledit moyen d'activation (112) comprend un générateur de faisceaux de particules, par exemple un générateur de faisceaux d'électrons.

25. Chambre de traitement (2) selon l'une quelconque des revendications 1 à 24, dans laquelle ledit moyen conducteur (16) est refroidi par un écoulement fluide.

26. Chambre de traitement (2) selon l'une quelconque des revendications 1 à 25, comprenant en outre un moyen de polarisation pour polariser électriquement ledit moyen conducteur (16) avec une tension alternative (comprenant une tension RF) ou une tension continue (comprenant la masse)/

27. Chambre de traitement (2) selon la revendication 26, dans laquelle ledit moyen conducteur (16) est divisé en deux ou plusieurs sections isolées, ledit moyen de polarisation étant actif pour polariser lesdites sections séparément.

28. Chambre de traitement (2) selon l'une quelconque des revendications 1 à 27, dans laquelle ledit moyen conducteur (16) comprend en outre au moins une partie à fenêtre (38) pour améliorer l'allumage du plasma.

29. Chambre de traitement (2) selon la revendication 28, comprenant en outre des moyens à volets (40) pour ajuster le degré d'ouverture de ladite fenêtre (38).

30. Chambre de traitement (2) selon l'une quelconque des revendications 1 à 29, comprenant en outre un plateau support de pièce qui peut être connecté à une source de polarisation pour polariser une pièce sur ledit plateau, soit directement soit par l'intermédiaire d'un support à température régulée, avec une tension alternative (comprenant une tension RF) ou une tension continue (comprenant la masse).

31. Chambre de traitement (2) selon l'une quelconque des revendications 1 à 30, comprenant en outre une cible de pulvérisation.

32. Appareil de traitement par plasma, comprenant :
une chambre de traitement selon l'une quelconque des revendications précédentes,
un inducteur d'énergie électromagnétique (4) à l'extérieur de ladite chambre de traitement pour y délivrer de l'énergie électromagnétique, et
une source d'énergie (6) pour entraîner ledit inducteur.

33. Appareil de traitement par plasma, selon la revendication 32, comprenant en outre un moyen de polarisation pour polariser le moyen conducteur (16) de la chambre de traitement (2) avec une tension alternative (comprenant une tension RF) ou une tension continue (comprenant la masse).

34. Appareil de traitement par plasma, selon la revendication 33, dans lequel ledit moyen de polarisation comprend un moyen pour polariser indépendamment deux sections isolées ou plus du moyen conducteur (16) de la chambre de traitement (2).

35. Utilisation d'un appareil de traitement par plasma selon l'une quelconque des revendications 32 à 34 pour déposer un film conducteur sur une pièce.

36. Utilisation d'un appareil de traitement par plasma selon l'une quelconque des revendications 32 à 34 pour la gravure ionique sur une pièce.
